## Europäisches Patentamt
## European Patent Office
## Office européen des brevets

(19)

(11) Numéro de publication: **0 268 506**
**A1**

(12)

# DEMANDE DE BREVET EUROPEEN

(21) Numéro de dépôt: 87402217.1

(51) Int. Cl.⁴: **G 01 R 31/28**

(22) Date de dépôt: 06.10.87

(30) Priorité: 10.10.86 FR 8614148

(43) Date de publication de la demande:
25.05.88 Bulletin 88/21

(84) Etats contractants désignés: DE GB IT NL SE

(71) Demandeur: THOMSON-CSF
173, Boulevard Haussmann
F-75379 Paris Cédex 08 (FR)

(72) Inventeur: Dias, Bernard
THOMSON-CSF SCPI 19, avenue de Messine
F-75008 Paris (FR)

Du Chene, Arnaud
THOMSON-CSF SCPI 19, avenue de Messine
F-75008 Paris (FR)

(74) Mandataire: Benoit, Monique et al
THOMSON-CSF SCPI 19, avenue de Messine
F-75008 Paris (FR)

(54) Dispositif et procédé de génération de vecteurs de test et procédé de test pour circuit intégré.

(57) L'invention se rapporte à un dispositif et à un procédé de génération de vecteurs de test pour circuit intégré et procédé de test pour circuit intégré.

L'invention a pour objet un dispositif et un procédé de test de circuit intégré notamment des P.L.A.. L'invention consiste à déterminer tous les défauts possibles d'un tel circuit que l'on veut pouvoir tester. A partir dudit défaut on détermine un ensemble de vecteurs de test, chaque défaut modifiant au moins un des vecteurs de tests appliqués au circuit intégré (70) à tester. Il est possible d'utiliser des vecteurs de test qui sont modifiés par le plus de défauts possibles. La détermination des vecteurs de tests à partir des défauts qu'on veut pouvoir détecter permet aux tests d'utiliser un petit nombre de vecteurs tout en étant sûr de détecter tous les défauts que présente un circuit donné.

Avantageusement, on détermine un ensemble hiérarchisé des cellules certaines cellules étant composées elles-mêmes de cellules plus petites.

Le procédé et dispositif selon la présente invention permet notamment de tester des P.L.A. en utilisant un faible nombre de vecieures de test.

L'invention s'applique principalement aux tests des circuits intégrés.

L'invention s'applique principalement aux test des P.L.A..

## FIG. 53

**Description**

DISPOSITIF ET PROCEDE DE GENERATION DE VECTEURS DE TEST ET PROCEDE DE TEST POUR CIRCUIT
INTEGRE

La présente invention se rapporte à un dispositif et à un procédé de génération de vecteurs de test et à un procédé de test pour circuit intégré.

En utilisant les technologies actuelles de fabrication de circuits intégrés pour augmenter le nombre des circuits intégrés produits et ainsi en diminuer le prix, on a tendance à en réduire la taille, souvent à la limite des possiblités technologiques. Au cours du processus de fabrication on se retrouve avec des circuits intégrés fonctionnant parfaitement, ainsi qu'avec des circuits intégrés comportant des défauts. Il est impératif de pouvoir séparer de façon efficace les circuits intégrés susceptibles de fonctionner correctement des circuits présentant des défauts. De plus, on essaye d'effectuer les tests des circuits le plus tôt possible, par exemple sur la tranche comportant une pluralité de circuits (wafer en terminologie anglo-saxonne). Ainsi on ne poursuit le processus de fabrication des circuits intégrés que pour ceux qui répondent correctement aux tests.

D'une part, il est connu de tester des circuits intégrés en leur appliquant toutes les combinaisons de signaux possible et en vérifiant que les réponses fournies par les circuits intégrés sont conformes aux résultats escomptés. Pour les circuits combinatoires on dit alors que le test est complet, dans la mesure où il n'y a pas d'effet de mémoire interne au circuit qui rendrait ledit circuit séquentiel. La longueur d'une séquence de test exhaustif croît exponentiellement avec le nombre de bits des vecteurs de test à appliquer au circuit. Avec les circuits modernes, comportant un nombre d'entrées important et donc exigeant des séquences de tests longues, il est généralement impossible, ou extrêmement coûteux de faire un test exhaustif d'un circuit intégré.

En effet ce test durerait très longtemps et exigerait une taille mémoire exagérée du dispositif de test.

D'autre part, il est connu de réduite le nombre de vecteurs de test appliqués à un circuit intégré.

Soit on se restreint aux vecteurs de test qui permettent la détection d'une liste réduite de fautes considérées possibles, soit en envoie une séquence de vecteurs pseudoaléatoires qui a une chance importante de détecter tout défaut du circuit.

Les méthodes de type exhaustif présentent le défaut d'utiliser un nombre de vecteurs important. De plus, les méthodes de type connu sont complètement inapplicables aux circuits logiques programmables appelés P.L.A. (terminologie anglo-saxonne) dans la suite de ce brevet.

Alors que, dans le cas d'un circuit combinatoire constitué d'opérateurs logiques de base il a été possible de définir quelques classes de fautes à la fois simples et suffisamment générales pour pouvoir modéliser les défaillances dans les différentes technologies (collages à 0 ou à 1, ...), cela n'est pas possible dans le cas des P.L.A.

Un collage à 0 d'une équipotentielle d'un circuit intégré est un défaut dudit circuit consistant à associer la valeur "0" à cette patte indépendamment du signal présent sur ladite équipotentielle.

Un collage à 1 d'une équipotentielle d'un circuit intégré est un défaut dudit circuit consistant à associer la valeur "1" à une équipotentielle dudit circuit intégré indépendamment de la valeur du signal présent.

Une coupure est la discontinuité d'un conducteur électrique.

Un court-circuit est la connexion accidentelle de deux équipotentielles d'un circuit électrique.

La création d'un opérateur supplémentaire est la création d'un transistor ou d'une diode parasite, qui n'a pas été prévue lors de la conception du circuit intégré.

Ce cas est considéré comme impossible dans la technologie utilisant les transistors de Schottky (STL en terminologie anglo-saxonne) comme d'ailleurs dans la plupart des technologies de type bipolaire.

Pour ces technologies, le test d'un ensemble d'opérateurs logiques peut se résumer au test du bon fonctionnement de chacun des opérateurs et de chacune des connexions. Par contre pour les circuits de type P.L.A. un test de ce type ne détecterait pas tous les défauts possibles.

Le problème du test des P.L.A. a donc son origine dans l'impossibilité de définir la modélisation de ses défaillances dans le cas général.

Le dispositif et le procédé selon la présente invention permettent un test efficace des défauts logiques d'un circuit intégré tout en diminuant la quantité de vecteurs de tests nécessaire.

Dans une première étape on détermine tous les défauts possibles que l'on veut pouvoir détecter. Dans une seconde étape on génère une séquence de test qui permette la détection de ces défauts, c'est-à-dire entraînant une séquence de réponses du circuit fausse lorsqu'un quelconque des défauts est présent.

La méthode est suffisamment générale pour pouvoir traiter tous les circuits logiques y compris les P.L.A..

Avantageusement, on établit un schéma équivalent du circuit que l'on veut tester, ledit schéma équivalent pouvant être traité par un générateur de vecteurs de test de type connu. On construit le schéma équivalent de telle façon que chaque défaillance possible du circuit se traduise dans le schéma équivalent par un collage à 1 de l'une des connexions. Il est bien évident que le schéma équivalent du circuit à tester, par exemple du P.L.A. assure la même fonction logique que le circuit remplacé pour le test.

L'idée du schéma équivalent peut être appliquée à n'importe quelle technologie. Toutefois, la structure de celui-ci est dépendante des défauts de production envisagée. Certaines défaillances nécessitent la prise en compte de l'implémentation du circuit, c'est le cas par exemple des courts-circuits entre pistes adjacentes.

Dans une variante de réalisation de l'invention le schéma équivalent comporte des ensembles de cellules hiérarchisées. Les cellules de base du schéma équivalent utilisent par exemple des primitives du simulateur HILO : par exemple NOT, BUF, AND, NAND, OR, NOR. Un schéma équivalent présente les caractéristiques suivantes:
- il assure la même fonction logique que le circuit, ou P.L.A. à tester ;
- chaque défaillance se traduit par le collage à 1 de l'un des fils; le nombre des collages à 1 inutile, car ne représentant pas une défaillance, est minimisé ;
- il a une structure générale standard permettant une adaptation simple à chaque circuit particulier.

L'utilisation d'une structure en cellules hiérarchisées par exemple utilisant des macrocellules et des cellules de base permet d'obtenir une structure régulière du schéma équivalent. Il est donc possible d'en faire la saisie graphique ou de décrire directement les circuits en langage HILO. Le schéma équivalent consiste donc en un assemblage de cellules communes à tous les circuits décrites une fois pour toutes. Seul l'assemblage des diverses cellules dépend du circuit particulier.

La détermination des défauts possibles permettant l'obtention d'un schéma équivalent nécessite la connaissance du schéma d'implémentation du P.L.A. et notamment de :
- l'adjacence des pistes ;
- la position relative des connexions verticales appelées via sur les pistes de variables ;
- la position relative des diodes sur les pistes de monômes ;
- la position relative des via sur les pistes de monômes ;
- la position relative des émetteurs des transistors sur les pistes de sorties ;
- les groupements de diodes dans un même motif ;
- les regroupements de transistors dans un même motif.

L'invention a principalement pour objet un dispositif de génération de vecteurs de test pour circuits intégrés, caractérisé par le fait qu'il comporte des moyens de communcation et au moins un calculateur, les moyens de communcation permettant d'acquérir une description d'un circuit, le calculateur étant susceptible de prendre en compte les défauts possibles dans le circuit intégré, c'est-à-dire les collages à 1 de son schéma équivalent, et d'associer à ces collages à 1 un ensemble de vecteurs de test, chaque collage à 1 étant susceptible de modifier au moins un vecteur.

L'invention a aussi pour objet un procédé de génération de vecteurs de test pour circuits intégrés, caractérisé par le fait que ledit procédé comporte une étape de détermination de défauts logiques possibles et une étape de génération d'au moins un vecteur de test par défaut logique possible, tel que ledit vecteur appliqué audit circuit logique donnera une réponse qui sera affectée par l'existence dudit défaut logique.

L'invention sera mieux comprise au moyen de la description ci-après et des figures annexées données comme des exemple non limitatifs, parmi lesquels :
- la figure 1 est un schéma d'une matrice ET d'un P.L.A. ;
- la figure 2 est un schéma d'une matrice OU d'un P.L.A. ;
- la figure 3 est un schéma d'une matrice ET d'un P.L.A. ;
- la figure 4 est un schéma d'une matrice OU d'un P.L.A. ;
- la figure 5 est un schéma d'une matrice ET d'un P.L.A. ;
- la figure 6 est un schéma d'une matrice OU d'un P.L.A. ;
- la figure 7 est un schéma réel d'une partie d'un circuit ;
- la figure 8 est un schéma équivalent du circuit de la figure 7 ;
- la figure 9 est un schéma d'une matrice ET d'un P.L.A. ;
- la figure 10 est un schéma équivalent du circuit illustré sur la figure 9 ;
- la figure 11 est un schéma d'une matrice OU d'un P.L.A. ;
- la figure 12 est un schéma équivalent du circuit illustré sur la figure 11 ;
- la figure 13 est un schéma d'une matrice ET d'un P.L.A. ;
- la figure 14 est un schéma équivalent du circuit illustré sur la figure 13 ;
- la figure 15 est un schéma d'une matrice OU d'un P.L.A. ;
- la figure 16 est un schéma équivalent du circuit illustré sur la figure 15 ;
- la figure 17 est un schéma d'une piste de variable d'un P.L.A. ;
- la figure 18 est un schéma équivalent du circuit de la figure 17 ;
- la figure 19 est un schéma d'une matrice ET d'un P.L.A. ;
- la figure 20 est un schéma équivalent du circuit illustré sur la figure 19 ;
- la figure 21 est un schéma d'une matrice OU d'un P.L.A. ;
- la figure 22 est un schéma équivalent du circuit illustré sur la figure 21 ;
- la figure 23 est un schéma d'une piste de sortie d'un P.L.A. ;
- la figure 24 est le schéma équivalent du circuit illustré sur la figure 22 ;
- la figure 25 est un schéma équivalent des pistes variables d'un P.L.A. non optimisé ;
- la figure 26 est un schéma équivalent des pistes de sortie d'un P.L.A. non optimisé ;
- la figure 27 est un schéma équivalent des connexions entre pistes de monômes et pistes de variables d'un P.L.A. ;
- la figure 28 est un schéma équivalent des connexions entre pistes de sorties et pistes de monômes d'un P.L.A. ;
- la figure 29 est un schéma d'une cellule EV (S, SB, E) ;
- la figure 30 est un schéma d'une cellule ENN (S, A(1:n), R(1:n), Z(1:n),E) ;

- la figure 31 est un schéma d'une cellule NPn (S(1:n), E(1:n)) ;

- la figure 32 est un schéma d'une cellule BPn (S(1:n), E(1:n)) ;

- la figure 33 est un schéma d'une cellule OUn (S, E(1:n)) ;

- la figure 34 est un schéma d'une cellule OBn (S, E(1:n)) ;

- la figure 35 est un schéma d'une cellule SNn (S, A(1:n), R(1:n), Z(1:n), E) ;

- la figure 36 est un schéma d'une cellule BSn (S(1:n), E) ;

- la figure 37 est un schéma d'une cellule NBn (S(1:n), E) ;

- la figure 38 est un schéma d'une cellule ETn (S, E(1:n)) ;

- la figure 39 est un schéma d'une cellule OSn (S, E(1:n)) ;

- la figure 40 est un schéma équivalent d'une macrocellule ENT (S(1:v), E(1:n)) ;

- la figure 41 est une variante de réalisation du dispositif de la figure 40 ;

- la figure 42 est une variante de réalisation du dispositif de la figure 41 ;

- la figure 43 est un schéma équivalent d'une macrocellule CCV (S(1:v), E(1:v)) ;

- la figure 44 est un schéma, au niveau des primitives de la macrocellule illustrée sur la figure 43 ;

- la figure 45 est un schéma d'une macrocellule CMV (S(1:m), E(1:m)) ;

- la figure 46 est un schéma d'une macrocellule CSM (S(1:s), E(1:s)) ;

- la figure 47 est un schéma d'une macrocellule CCS (S(1:s), E(1:s)) ;

- la figure 48 est un schéma d'une macrocellule CCM (S(1:m), E(1:m)) ;

- la figure 49 est un exemple d'un schéma équivalent d'un P.L.A. ;

- la figure 50 est un schéma montrant le groupement des motifs d'un P.L.A. particulier ;

- la figure 51 est un schéma équivalent du P.L.A. illustré par la figure 50 ;

- la figure 52 est la description en langage du simulateur HILO du circuit de la figure 51 ;

- la figure 53 est un schéma du dispositif selon l'invention ;

- la figure 54 est un organigramme d'un programme utilisé par le dispositif de la figure 53.

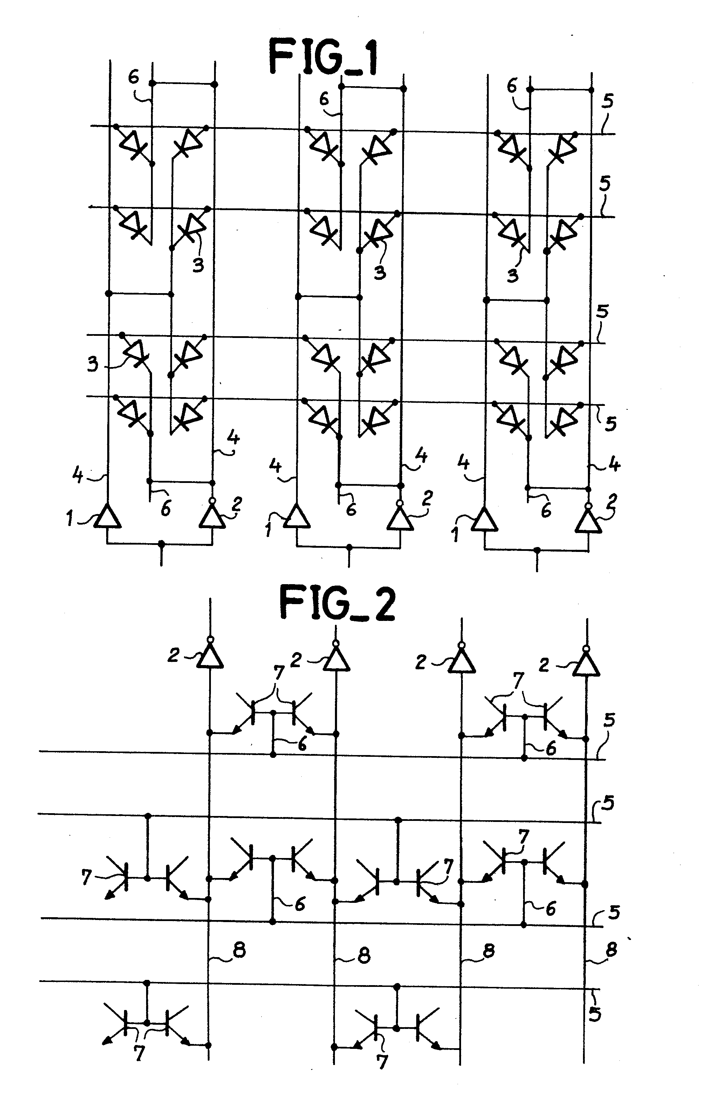

Sur la figure 1 à 54 on a utilisé les mêmes références pour désigner les mêmes éléments.

Sur les figures 1 à 52 on a représenté un exemple de réalisation de test pour un circuit P.L.A.. Il est bien entendu que l'invention ne se limite pas aux tests des circuits P.L.A.

Sur la figure 1, on peut voir une matrice ET d'un P.L.A. La matrice ET comporte reliés à chacune des entrées un interface d'entrée 1 appelé buffer dans la suite de ce brevet et un buffer d'entrée inverseur 2. Les buffers 1 et 2 sont reliés à des lignes de variables 4. Les lignes de variables 4 sont reliées par des connexions verticales 6 (via en terminologie anglo-saxonne) et par des diodes 3 aux lignes de monôme 5. Un circuit peut être défaillant par suite d'une mauvaise réalisation d'un de ses motifs, par exemple, les défauts de fabrication des interfaces d'entrée 1 ou 2, d'une diode ou la réalisation incorrecte d'un via entre les diverses couches d'aluminium.

Sur la figure 2, on peut voir une matrice OU d'un P.L.A. La matrice OU comporte des lignes de monômes 5 reliées à des lignes de sortie 8 par l'intermédiaire de connexions verticales 6 et des transistors 7. Les lignes de sortie 8 comportent à leurs extrémités des interfaces de sortie 2 inverseuses.

Dans la matrice OU la défaillance de motif peut provenir d'un défaut de fabrication d'un transistor, d'une résistance ou la réalisation incorrecte d'une connexion verticale 6.

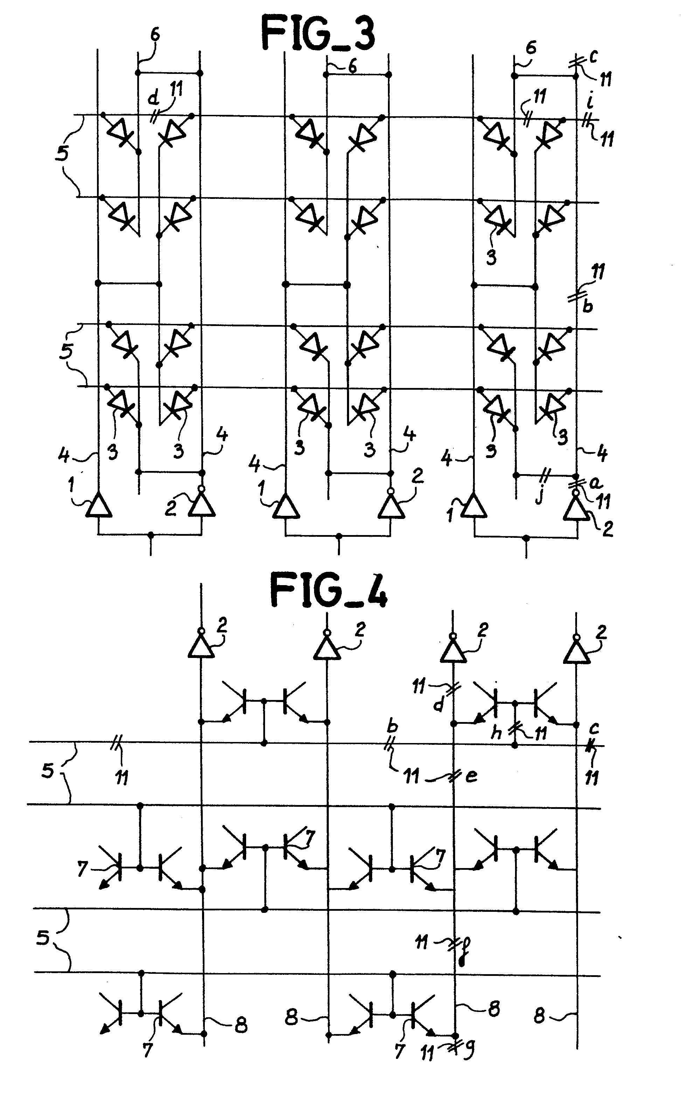

Sur la figure 3, on peut voir une matrice ET d'un P.L.A. La matrice de la figure 3 comporte divers types de coupures de piste 11 possibles. Selon les effets produits les coupures sont référencées alphabétiquement de a à i. Il sera en général nécessaire de produire des vecteurs de test différents selon l'endroit de la coupure.

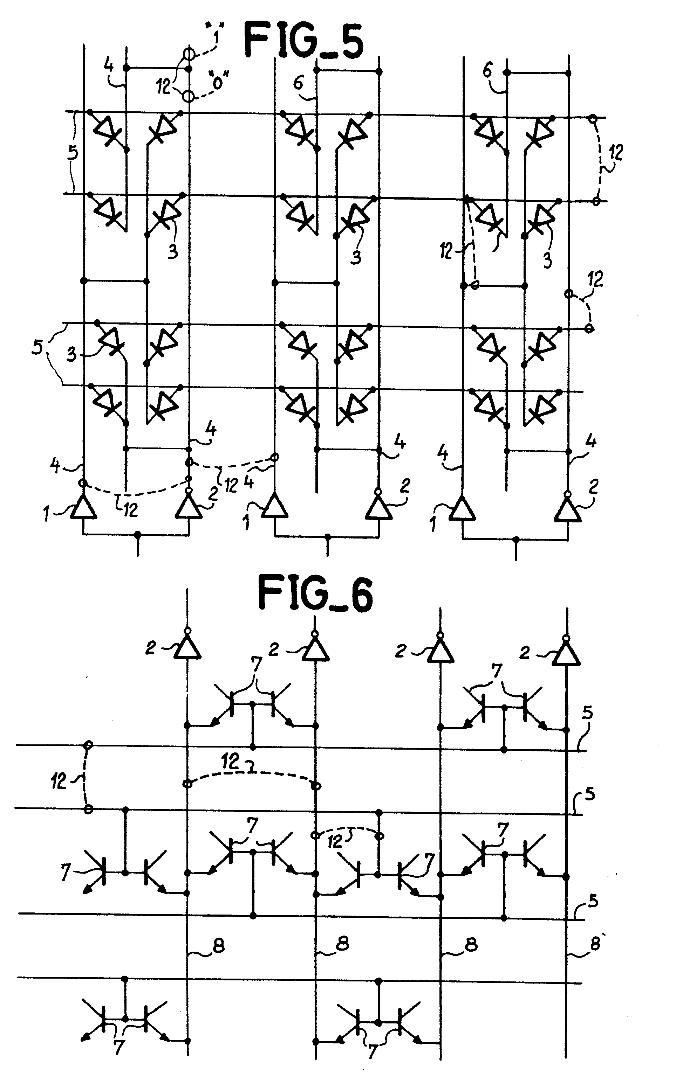

Sur la figure 4, on peut voir une matrice OU d'un P.L.A. sur lequel ont été représentées les coupures 11 affectant le bon fonctionnement du circuit. Les coupures 11 sont notées de a à h selon leur position qui affecte de façon différente le fonctionnement du circuit. Les coupures de pistes peuvent se produire dans les diverses couches de métallisation composant le P.L.A. Dans la plupart des cas les couches de métallisation sont en aluminium. Dans une technologie utilisée par la Demanderesse la première couche d'aluminium comporte des pistes de largeur 5,5 microns et la deuxième couche d'aluminium des pistes de largeur 11 microns.

Sur la figure 5, on peut voir une matrice ET sur laquelle on a illustré référencés 12 les divers courts-circuits possibles. La ligne pointillée indique le chemin électrique du court-circuit. Sur la ligne de variables 4 on a indiqué les courts-circuits avec l'alimentation assurant un collage à 1 ou un collage à 0.

Sur la figure 6, on peut voir les courts-circuits 12 pouvant affecter la matrice OU d'un P.L.A.

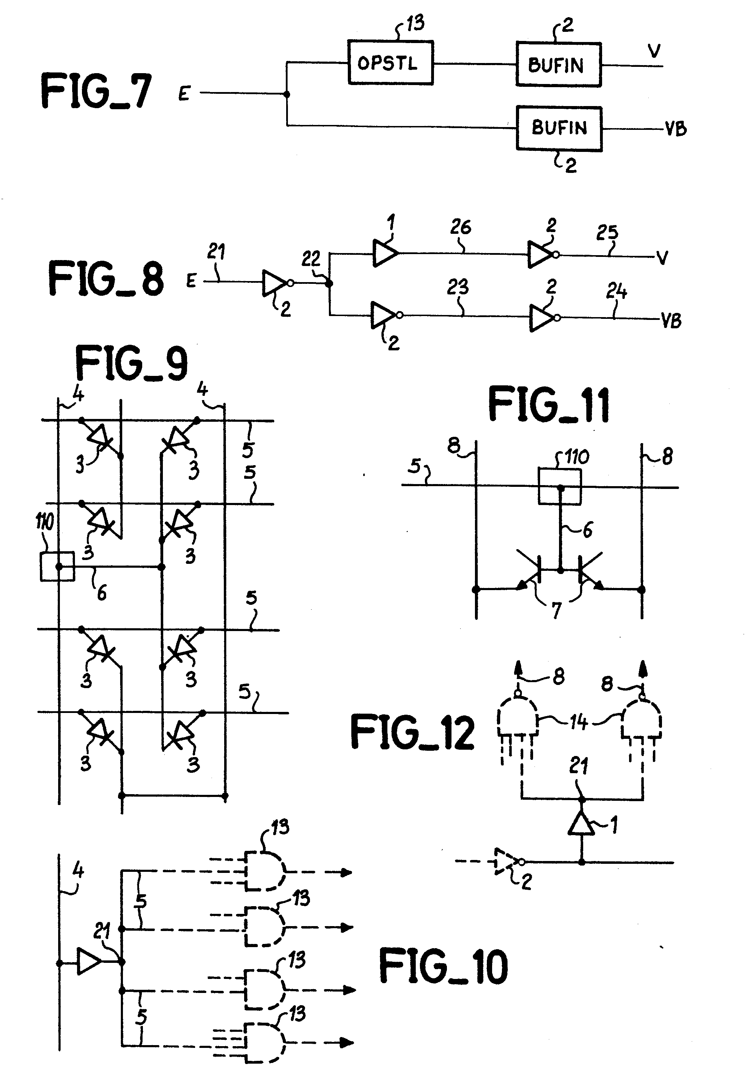

Sur la figure 7, on peut voir un exemple d'un circuit logique d'entrée de P.L.A., sur la figure 8 son schéma équivalent. Le dispositif de la figure 7 comporte une entrée E reliée à une première branche comportant un opérateur en logique à transistor de Schottky 13 et buffer inverseur 2 et une seconde branche comportant uniquement un buffer inverseur 2. Sur la sortie de la première branche nous sommes en présence d'une tension V, sur la sortie de la seconde branche nous sommes en présence d'une tension VB.

Le schéma équivalent comporte un buffer inverseur 2 relié à deux branches. La première branche comporte mis en série un buffer 1 et un buffer inverseur 2. La seconde branche comporte reliés en série deux buffers inverseurs 2.

Une défaillance consistant en un collage à 0 de E est équivalente sur la figure 8 à un collage à 1 du noeud 22.

Une défaillance consistant en un collage à 1 de E est équivalente sur la figure 8 à un collage à 1 du noeud 21.

Une défaillance consistant en un collage à Ø de V est équivalente à un collage à 1 du noeud 26.

Une défaillance consistant en un collage à 1 de V est équivalente à un collage à 1 du noeud 25.

Une défaillance consistant en un collage à Ø de VB est équivalente sur la figure 8 à un collage à 1 du noeud 23.

Une défaillance consistant en un collage à 1 de VB est équivalente sur la figure 8 à un collage à 1 du noeud 24.

Sur la figure 9, on peut voir une matrice ET. Dans la matrice ET, l'absence d'un via se traduit par l'élimination de la variable correspondante dans les n monômes concernés. n est le nombre de diodes dans le motif contenant le via défectueux. n est par exemple compris entre 1 et 4.

Sur la figure 10, on peut voir un schéma équivalent du dispositif de la figure 9. La ligne de variable 4 est reliée par un buffer 1 à n lignes de monômes 5. Les lignes de monômes comportent par exemple deux portes 13. Sur le schéma équivalent de la figure 10 les défaillances des connexions verticales se traduisent par un collage à 1 de la sortie 21 du buffer utilisé n fois.

Sur la figure 11, on peut voir une matrice OU. Dans la matrice OU, l'absence d'un via se traduit par l'élimination du monôme correspondant dans les n' sorties concernées. n' est le nombre de transistors dans le motif contenant le via défectueux. n' est par exemple égal à 1 ou à 2.

Sur la figure 12, on peut voir le schéma équivalent du dispositif de la figure 11. Sur la figure 12 les défaillances se traduisent par un collage à 1 de la sortie 21 d'un buffer 2 utilisé n' fois.

Ainsi sur les figures 9 à 12 une absence de connexion verticale 6 se traduit par un collage à 1 du noeud 21.

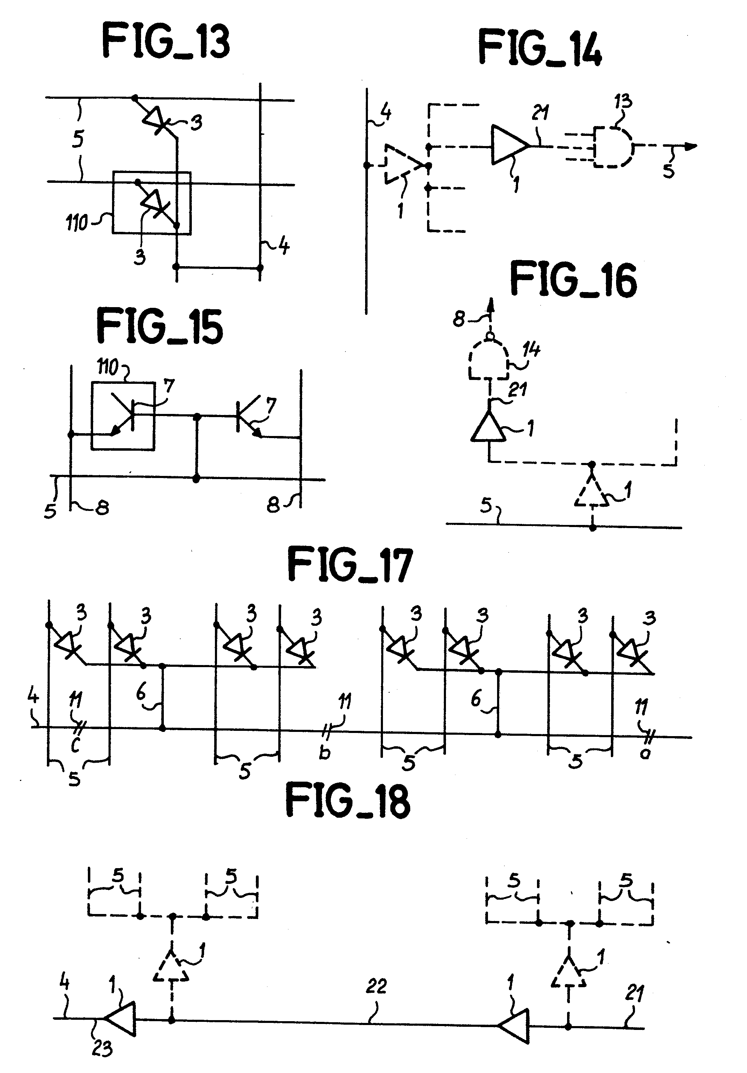

Sur la figure 13, on peut voir une matrice ET d'un P.L.A. Un défaut 110 consistant en une absence de diode se traduit sur le schéma équivalent de la figure 14 par l'élimination de la variable correspondant dans l'expression d'un monôme. Ainsi sur le schéma équivalent de la figure 14 le défaut 110 de la figure 13 se traduit par un collage à 1 au point 21 de la sortie du buffer 1.

Sur la figure 15, on peut voir une matrice OU dont un des transistors 7 comporte un défaut 110. L'absence d'un transistor 7 se traduit par l'élimination du monôme correspondant dans l'expression logique d'une sortie. Elle se traduit sur le schéma équivalent de la figure 16 par un collage à 1 de la sortie 21 d'un buffer.

Du point de vue logique l'absence d'une résistance d'alimentation est équivalente à une coupure sur la ligne de monôme correspondante à l'entrée de la matrice OU.

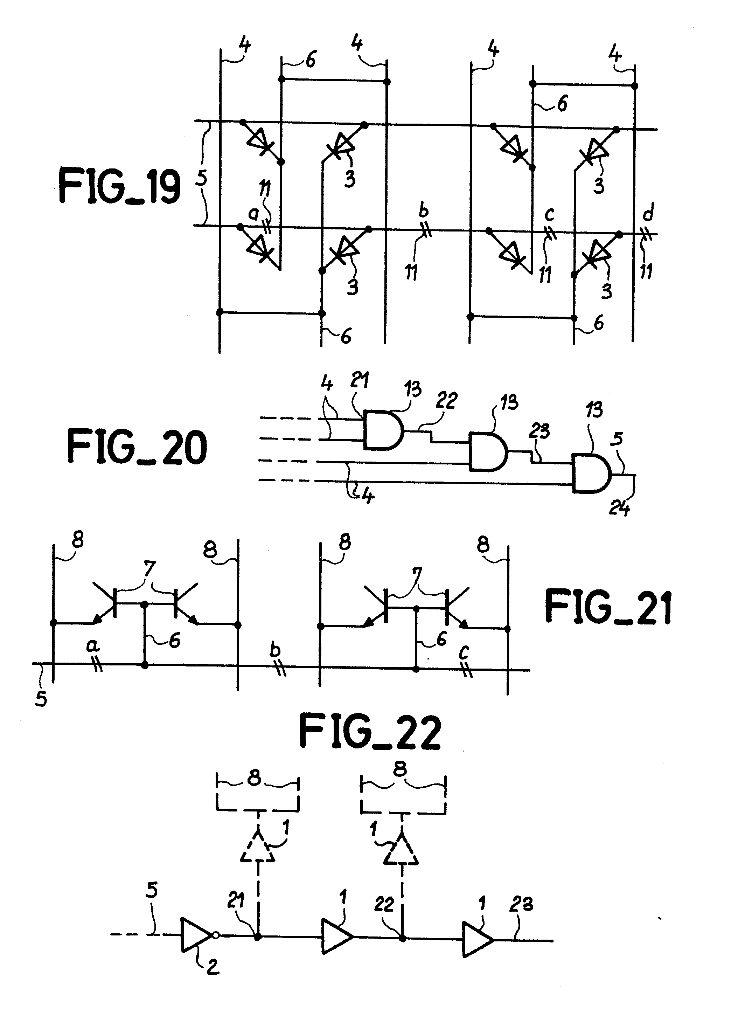

Sur la figure 17, on peut voir le schéma d'une piste de variable 4, tandis que sur la figure 18 on peut voir un schéma équivalent du dispositif de la figure 17. La coupure d'une piste de variable a pour conséquence la disparition de la variable dans l'expression de tous les monômes situés physiquement en aval de la coupure. Sur le schéma équivalent de la figure 18 elle se traduit par un collage à 1 d'un buffer.

La coupure de la piste de variable 4 en a est équivalente à un collage à 1 du noeud 21 de la figure 18.

La coupure de la piste de variable 4 en b est équivalente à un collage à 1 du noeud 22 de la figure 18.

La coupure de la piste de variable 4 en c est équivalente à un collage à 1 du noeud 23 de la figure 18.

Sur la figure 19, on peut voir le schéma d'une matrice ET. Sur la figure 20 on peut voir le schéma équivalent du dispositif de la figure 19. Une coupure de piste de monôme dans la matrice ET a pour conséquence la disparition dans l'expression du monôme des variables connectées physiquement en amont de la coupure. Elle se traduit sur le schéma équivalent de la figure 20 par un collage à 1 d'une des sorties des éléments ET logique 13. Le schéma équivalent de la figure 20 comporte connectées en cascades des portes logiques ET 13. La sortie de chaque porte logique ET 13 est connectée à l'une des deux entrées de la porte logique ET suivante. La sortie de la dernière porte logique ET 13 représente la ligne de monômes.

La coupure de la piste de monômes 5 en a est équivalente à un collage à 1 du noeud 21 de la figure 20.

La coupure de la piste de monômes 5 en b est équivalente au collage à 1 du noeud 22.

La coupure de la piste de monômes 5 en c est équivalente au collage à 1 du noeud 23 de la figure 20.

La coupure de la piste de monômes 5 en d est équivalente à un collage à 1 du noeud 24 de la figure 20.

Sur la figure 21, on peut voir une matrice OU ; sur la figure 22 on peut voir le schéma équivalent du dispositif de la figure 21. Sur la figure 21, on peut voir une ligne de monômes 5 comportant, connectés en série deux buffers 1. Le premier buffer 1 est précédé du noeud 21 et suivi du noeud 22. Le second buffer 1 est suivi du noeud 23. Sur la ligne de monômes 5 en amont du noeud 21 se trouve un buffer inverseur 2. Au noeud 21 est connecté un buffer 1 connecté à deux lignes de sortie 8. De même au noeud 23 est connecté un buffer 1 connecté à deux lignes de sortie 8.

Une coupure 11 d'une piste de monômes 5 dans une matrice OU a pour conséquence la disparition du monôme dans l'expression logique des sorties connectées physiquement en aval de la coupure 11. Elle se traduit par le collage à 1 d'un buffer dans le schéma équivalent.

La coupure 11 de la piste de monômes en a est équivalente au collage à 1 du noeud 21 de la figure 22.

La coupure 11 de la piste de monômes 5 en b est équivalente au collage à 1 du noeud 22 de la figure 22.

La coupure 11 de la piste de monômes 5 en c est équivalente au collage à 1 du noeud 23 de la figure 22.

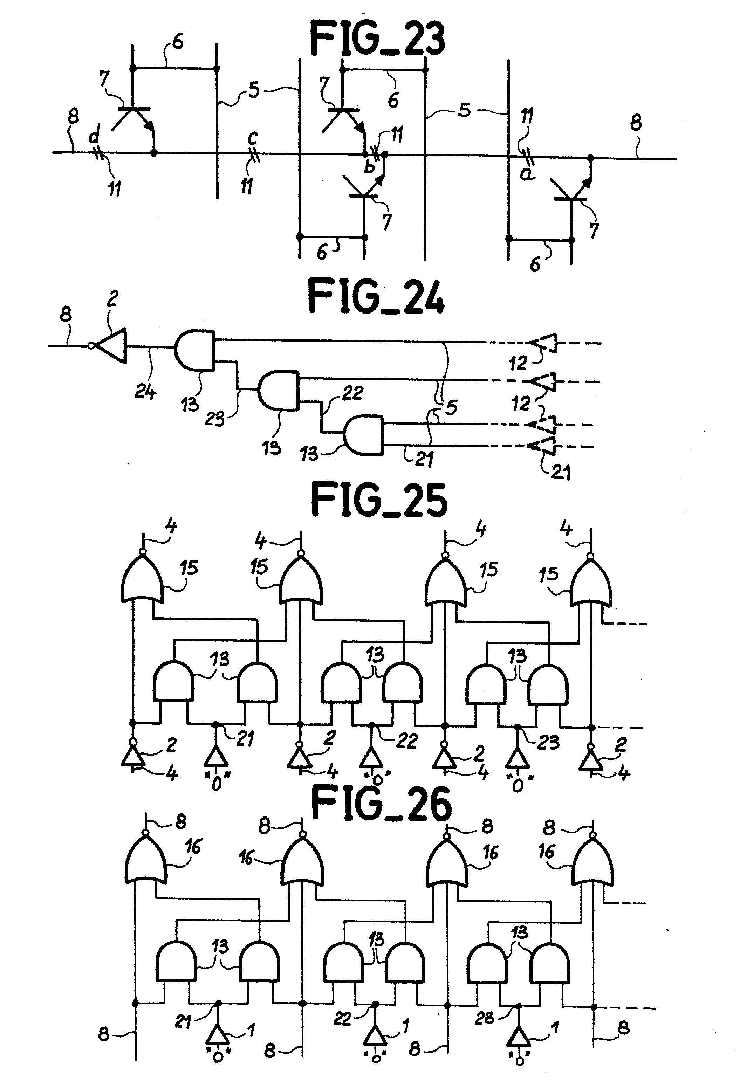

Sur la figure 23, on peut voir une piste de sortie 8 d'un P.L.A.

Sur la figure 24, on peut voir, connectés en cascades des opérateurs ET 13.

La sortie de chaque opérateur ET 13 est connectée à l'une des deux entrées de l'opérateur ET 13 suivant. La première entrée du premier opérateur 13 ET et les secondes entrées des opérateurs ET 13 suivants sont connectées, par l'intermédiaire d'un buffer 1 aux lignes de monômes 5. La sortie du dernier opérateur ET 13 est connectée par l'intermédiaire d'un buffer inverseur 2 à la ligne de sortie 8.

La coupure 11 d'une ligne de sortie 8 a pour conséquence la disparition dans l'expression logique de la sortie des monômes situés en amont de la coupure. Elle se traduit sur le schéma équivalent par un collage à 1 de la sortie d'un opérateur ET 13.

La coupure 11 de la piste de sortie 8 en a est équivalente à un collage à 1 du noeud 21 de la figure 24.

La coupure 11 de la piste de sortie 8 en b est équivalente au collage à 1 du noeud 22 de la figure 24.

La coupure 11 de la piste de sortie 8 en c est équivalente à un collage à 1 du noeud 23 de la figure 24.

La coupure de la piste de sortie 8 en d est équivalente à un collage à 1 du noeud 24 de la figure 24.

La coupure d'une connexion verticale 6 est équivalente à un collage à 1 d'un buffer 1 sur le schéma équivalent.

Sur la figure 25, on peut voir une partie du schéma équivalent d'un P.L.A. dans lequel on a incorporé des dispositifs permettant de détecter les courts-circuits entre pistes. Sur la figure 25 sont représentées quatre entrées de lignes de variables 4 reliées à des buffers inverseurs 2. Chaque sortie du buffer inverseur 2 est reliée d'une part à une première entrée d'une porte logique ET 13 et d'autre part à une première entrée d'une porte logique $\overline{OU}$ 15 (NOR en terminologie anglo-saxonne). Des buffers 1 sont connectés aux secondes entrées des portes logiques ET 13. La sortie de chaque porte logique ET 13 est reliée à une entrée de la porte logique $\overline{OU}$ 15 de la ligne de variables voisine.

L'injection d'un Ø par le buffer 1 permet de représenter un court-circuit entre pistes de variables adjacentes par un collage à 1. En effet, cette défaillance a pour conséquence de transformer la valeur logique de deux variables concernées en leur produit. Elle se traduit par le collage à 1 de la sortie d'un buffer sur le schéma équivalent. Dans le cas d'un P.L.A. optimisé, une piste de variables peut être adjacente à plus de deux pistes de variables. Le schéma équivalent à utiliser alors consiste en une généralisation du schéma illustré sur la figure 25.

De plus, le schéma de la figure 25 peut être utilisé pour les courts-circuits entre des pistes de monômes adjacentes. En effet, cette défaillance a pour conséquence de transformer l'expression logique des deux monômes en court-circuit en leur produit logique.

Le court-circuit entre la première et la seconde lignes de variables est équivalent à un collage à 1 du noeud 21 situé à la sortie du buffer 1 situé entre ces deux lignes sur la figure 25.

Le court-circuit entre la seconde et la troisième lignes de variables 4 est équivalent au collage à 1 du noeud 22 sur la figure 25 se trouvant entre lesdits lignes de variables.

Le court-circuit entre la troisième et la quatrième lignes de variables 4 est équivalent au collage à 1 du noeud 23 situé sur la figure 25 entre la troisième et la quatrième lignes de variables 4.

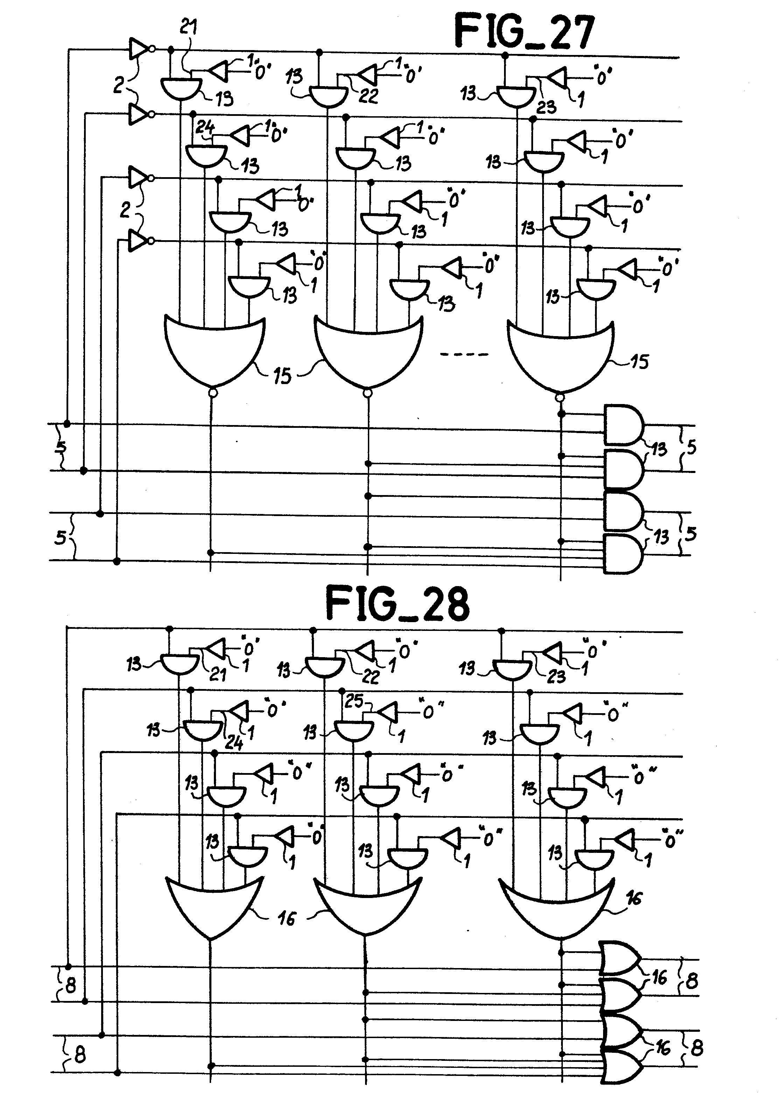

Sur la figure 26, on peut voir le schéma équivalent permettant de représenter les courts-circuits entre pistes de sorties adjacentes. Sur la figure 26, on peut voir le schéma équivalent permettant la détection des courts-circuits entre pistes de sortie 8 adjacentes.

Chaque piste de sortie 8 est connectée d'une part à une entrée d'une porte logique OU 16 (OR en terminologie anglo-saxonne), et d'autre part à une première entrée d'une porte logique ET 13. Un buffer 1 est connecté aux secondes entrées des portes logiques ET 13. La sortie de chaque porte logique ET 13 est reliée à une entrée desdites portes logiques OU 16 appartenant aux lignes de sortie 8 adjacentes.

Appliquer un zéro logique aux buffers d'entrée 1 permet de représenter par des collages à 1 les courts-circuits entre deux pistes de sortie 8. En effet, un court-circuit entre deux pistes de sortie 8 adjacentes a pour conséquence de transformer l'expression des deux sorties 8 en leur OU logique. IL se traduit donc sur le schéma de la figure 26 par un collage à 1 de la sortie d'un buffer.

Le court-circuit entre la première et la seconde lignes de sortie 8 est équivalent au collage à 1 du noeud 21 situé entre ces deux lignes.

Un court-circuit entre la seconde et la troisième lignes de sortie 8 sur le schéma 26 est équivalent au collage à 1 du noeud 22 situé entre ces deux lignes.

Sur la figure 27, on peut voir un schéma équivalent permettant de détecter les courts-circuits entre pistes de monômes 5 et pistes de variables 4. Dans une variante de réalisation non illustrée, il suffit de reboucler chacun des monômes sur chacune des variables, la boucle se fermant avec le collage à 1 d'un noeud. Toutefois, cette réalisation risque d'être inadaptée par suite de la présence desdites boucles à l'illusation d'un générateur automatique des séquences de tests actuel. Ainsi, avantageusement on est amené à utiliser le schéma équivalent de la figure 27.

Le dispositif de la figure 27 comporte des lignes de monômes 5 connectées d'une part à des entrées de buffers inverseurs 2. Les sorties des buffers inverseurs 2 sont connectées en série à des entrées de portes logiques ET 13. Les secondes entrées des portes logiques ET 13 sont reliées à des buffers 1. Les sorties des ensembles de portes logiques ET 13 reliées aux différents buffers inverseurs 2 sont reliées à des portes logiques $\overline{OU}$ 15.

Chaque sortie de la porte logique $\overline{OU}$ 15 est reliée aux entrées de la porte logique ET 13 reliée à la ligne de monômes 5, si la variable apparaît dans l'expression de ces monômes.

Dans l'exemple illustré sur la figure 27, la seconde ligne de monômes (en partant du haut) est égale au produit de la deuxième et de la dernière lignes de variables.

Un court-circuit entre piste de monôme et piste de variable a pour conséquence de remplacer la valeur logique de la variable par l'expression du monôme.

Le court-circuit entre la ligne 5 des monômes M(1) et la ligne de variables I (1) est équivalent sur la figure 27 au collage à 1 du noeud 21.

Le court-circuit entre la ligne 5 des monômes M(1) et la ligne de variables I (2) est équivalent sur la figure 27 au collage à 1 du noeud 22.

Le court-circuit entre la ligne 5 des monômes M(1) et la nième ligne de variables est équivalent sur la figure 27 au collage à 1 du noeud 23. n est le nombre de variables du P.L.A.

Le court-circuit entre la ligne 5 des monômes M(2) et la ligne de variables I (1) est équivalent sur la figure 27 au collage à 1 du noeud 24.

Sur la figure 28, on peut voir le schéma équivalent d'un circuit permettant de détecter un court-circuit entre une piste de sortie à une piste de monôme. Cette défaillance a pour conséquence de remplacer la valeur du monôme par celle de la sortie. De même que pour les courts-circuits entre piste de monôme 5 et piste de variable 4 on a utilisé un schéma équivalent ne comportant pas de rebouclage pour faciliter le travail des générateurs de vecteurs de tests automatiques.

Sur la figure 28, on a illustré quatre lignes de sortie 8, F(1) à F(4). Chaque ligne de sortie 8 est reliée d'une part à une première entrée d'une porte logique OU 16 et d'autre part en série à un ensemble de portes logiques ET 13. La seconde entrée des portes logiques ET 13 est reliée à des buffers 1. Les sorties des portes logiques ET 13 reliées aux quatre lignes de sortie 8 S(1) à S(4) sont reliées à m portes logiques OU 16 référencées I(1) à I(m). Chaque porte logique 16 I(i) est reliée à l'entrée des portes logiques OU 16 dont une entrée est reliée à une ligne de sortie 8 pour laquelle le ième monôme M(i) apparaît dans l'expression de la ligne de sortie correspondante.

Le court-circuit entre la ligne 8 de sortie S(1) et le premier monôme est équivalent sur la figure 28 au collage à 1 du noeud 21.

Le court-circuit entre la ligne 8 de sortie S(1) et le deuxième monôme est équivalent sur la figure 28 au collage à 1 du noeud 22.

Le court-circuit entre la ligne 8 de sortie S(1) et le mième monômes est équivalent sur la figure 28 au collage à 1 du noeud 23. m est le nombre de monômes du P.L.A.

Le court-circuit entre la ligne 8 de sortie S(2) et le premier monôme est équivalent sur la figure 28 au collage à 1 du noeud 24.

Le court-circuit entre la ligne 8 de sortie S(2) et le premier monôme est équivalent sur la figure 28 au collage à 1 du de noeud 25 et ainsi de suite.

Les lignes I(1) à I(M) sont toutes identiques. Toutefois, un vecteur de test permettant de détecter un collage à 1 en sortie d'un buffer 1, par exemple au noeud 25 permettra la détection d'un court-circuit entre une piste de sortie numéro 2 et le deuxième monôme.

Un court-circuit entre une piste de monôme et une piste de connexion verticale équivalent du point de vue logique au court-circuit entre la piste de monôme et la piste de variable 4 correspondant à la connexion verticale. On se retrouve donc dans le cas de la figure 27.

Un court-circuit entre une piste de sortie 8 et une piste de connexion verticale 6 est équivalent au court-circuit entre la piste de sortie 8 et la piste de monôme correspondant à la piste de connexion verticale 6.

Un court-circuit entre une piste de variable 4 et l'alimentation électrique correspond au niveau logique à un forçage à 0 ou à 1 de la valeur de la piste de variable 4. Il est donc équivalent à un collage à 0 ou à 1 d'un buffer d'entrée. Ce cas est illustré sur les figures 7 et 8. Un court-circuit entre une piste de monôme 4 et l'alimentation à pour conséquence le forçage à 0 ou à 1 de la valeur du monôme.

Un court-circuit entraînant le forçage à 1 est équivalent à la coupure de la piste de monôme 4 en d de la piste 5 de la figure 19.

Un court-circuit avec la masse équivalent à la coupure de la piste de monôme 5 en a sur la figure 21.

Avantageusement, on utilise pour la génération des vecteurs de tests eux-mêmes un générateur de test de type connu, par exemple le générateur de vecteurs de test HILO. La description pour le générateur de vecteurs de test du schéma équivalent peut être obtenu :

- par la saisie graphique du schéma équivalent puis en utilisant un interface avec le générateur de vecteurs de test ;

- en utilisant un interface avec la description dans un langage de niveau élevé par exemple le langage PAOLA ;

- la description directe avec l'éditeur.

Avantageusement, pour simplifier la saisie graphique ou la description directe du schéma équivalent dans un langage compréhensible par le générateur de vecteur de test, par exemple HILO, on utilise une structure régulière et hiérarchisée utilisant des cellules et des macrocellules.

Par exemple les cellules sont générales et décrites une fois pour toutes dans une librairie en langage HILO. Ces cellules étant simples, la description directe en format HILO ne pose pas de problème.

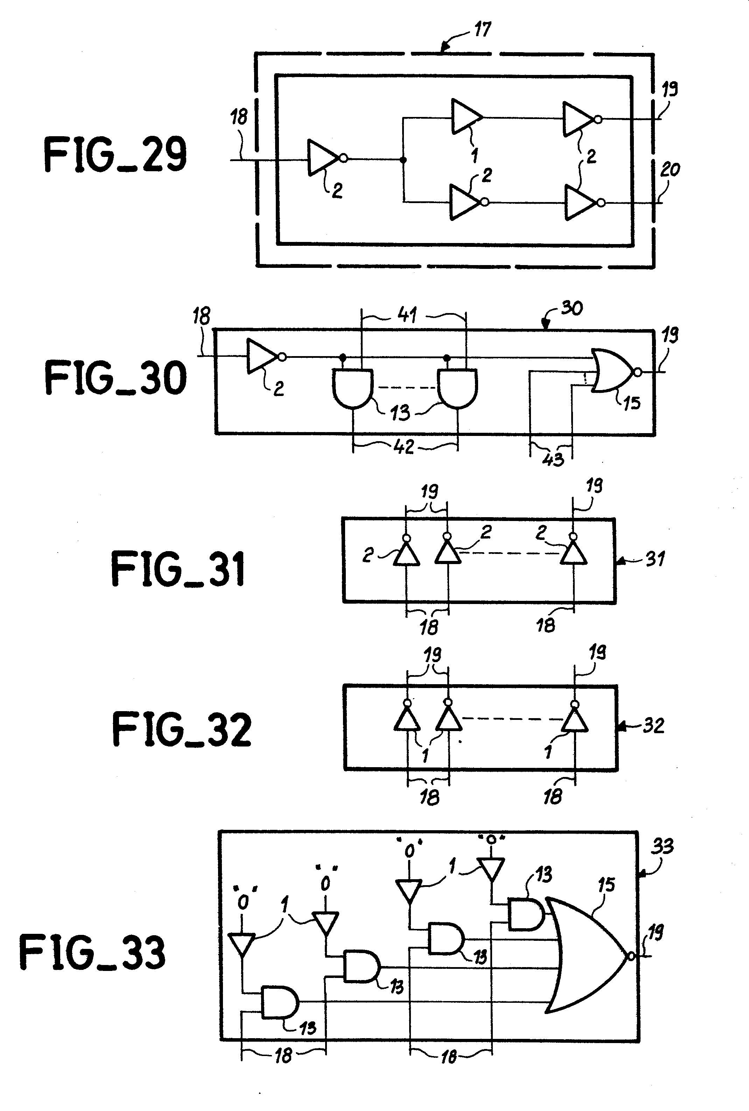

Des exemples de cellule non limitatifs sont illustrés sur les figures 29 à 39.

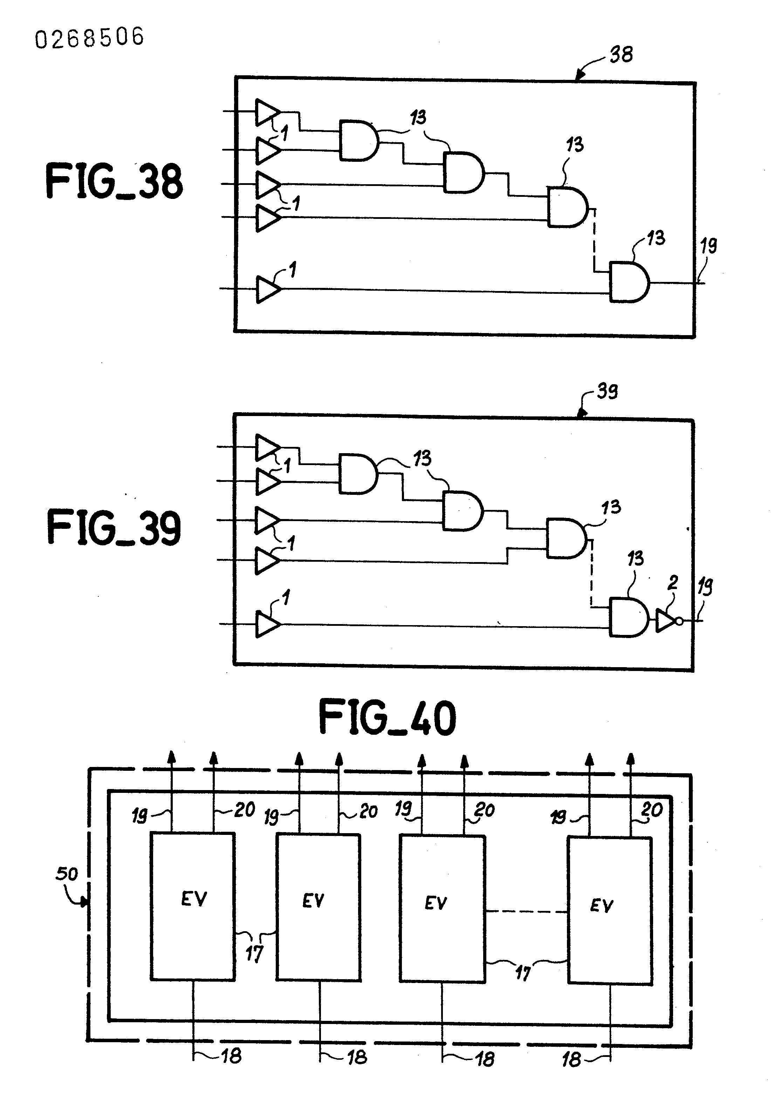

Les macrocellules sont composées de cellules et dépendent du circuit par exemple P.L.A. à modéliser. L'utilisation des macrocellules permet de simplifier le schéma équivalent. Des exemples de macrocellules sont illustrés sur les figures 40 à 47.

Sur la figure 29, on peut voir une cellule 17 appelée EDV(S, SB, E). La cellule 17 comporte une entrée 18 et deux sorties 19 et 20. L'entrée 18 est reliée à un premier buffer inverseur 2. La sortie du premier buffer inverseur 2 est reliée d'une part à un buffer 1 et à un buffer 2 reliés en série à la sortie 19 et d'autre part à deux buffers inverseurs reliés en série à la sortie 20.

Sur la figure 30, on peut voir une cellule 30 appelée ENn (S,A(1:n), R(1:n), Z(1:n), E) comportant une entrée 18, des entrées 41, des entrées 43, des sorties 42, et une sortie 19. Les entrées 41 sont reliées aux premières entrées des portes logiques ET 13. L'entrée 18 est reliée à un buffer inverseur 2. La sortie du buffer inverseur 2 est reliée d'une part en parallèle aux secondes entrées de portes logiques ET 13 et d'autre part à une porte logique $\overline{OU}$ 15. D'autre part, les entrées 43 sont reliées aux entrées de la porte $\overline{OU}$ 15. La sortie de la porte logique $\overline{OU}$ 15 est reliée à la sortie 19 de la cellule 30.

Sur la figure 31, on peut voir une cellule 31 appelée NPn (S(1:n), E(1:n)) comportant une pluralité de buffers inverseurs 2 placés en parallèle. Chaque buffer inverseur 2 est relié à une entrée 18 et à une sortie 19.

Sur la figure 32, on peut voir une cellule 32 appelée BPn (S(1:n), E(1:n)) comportant une pluralité de buffers 1 placés en parallèle. Chaque buffer 1 est relié à une entrée 18 et une sortie 19.

Sur la figure 33, on peut voir une cellule 33 appelée OUn (S, E(1:n)) comportant une pluralité d'entrées 18 et une sortie 19. Chaque entrée 18 est connectée à une première entrée d'une porte logique ET 13. Un 0 est susceptible d'être injecté dans chacune des portes logiques ET 13 par l'intermédiaire de buffer 1 connecté à une seconde entrée desdites portes logiques ET 13. Les sorties des portes logiques ET 13 sont reliées aux entrées d'une porte logique $\overline{OU}$ 15, la sortie de la porte logique $\overline{OU}$ 15 est reliée à la sortie 19 de la cellule 33.

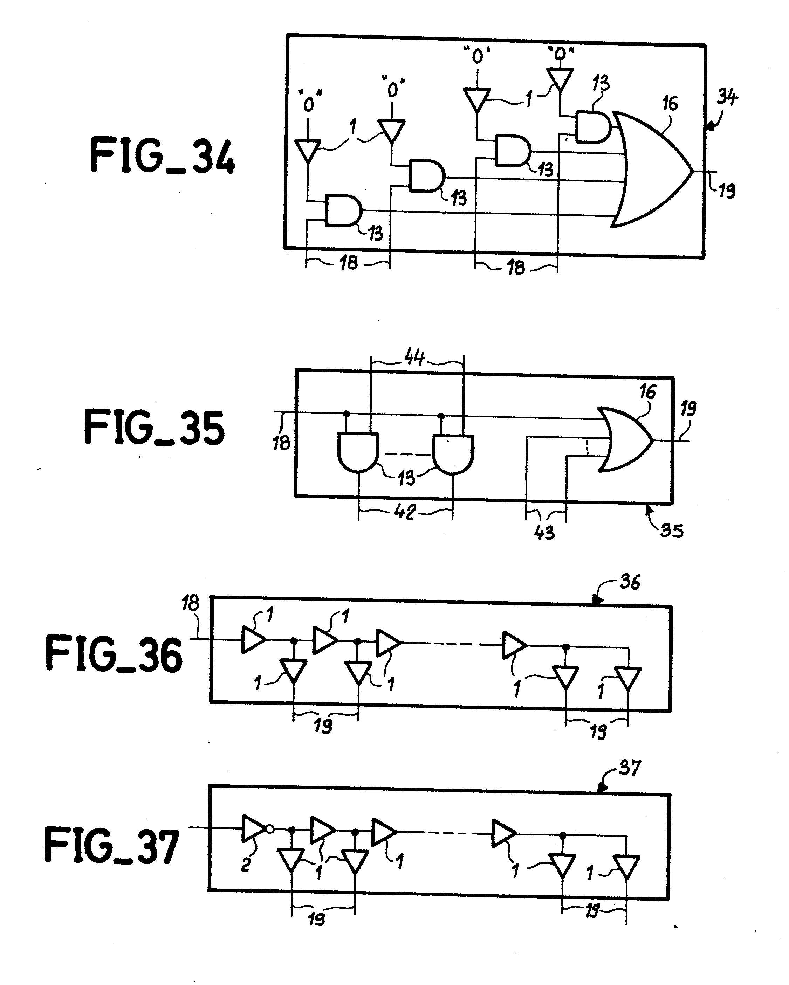

Sur la figure 34, on peut voir une cellule 34 appelée OBn (S, E(1:n)) comportant une pluralité d'entrées 18 et une entrée 19. Les entrées 18 sont reliées à une première entrée de portes logiques ET 13. Les secondes entrées de portes logiques ET 13 sont reliées à des buffers 1. Les buffers 1 permettent d'injecter des 0 sur une entrée de la porte logique ET 13. Les sorties des portes logiques ET 13 sont reliées à une porte logique OU 16. La sortie de la porte logique OU 16 est reliée à la sortie 19 de la cellule 34.

Sur la figure 35, on peut voir une cellule 35 appelée SNn (S, A(1:n), R(1:n), Z(1:n), E) comportant une entrée 18, des entrées 43 et 44, une sortie 19 et des sorties 42. L'entrée 18 est reliée en parallèle aux premières entrées des portes logiques ET 13 et à une première entrée d'une porte logique OU 16. D'autre part, chaque entrée 44 est reliée à une seconde entrée desdites portes logiques ET 13. Chaque sortie de portes logiques ET 13 est reliée à une sortie 42 de la cellule 35. Les entrées 43 sont reliées aux entrées d'une porte logique OU 16. La sortie de la porte logique OU 16 est reliée à la sortie 19 de la cellule 35.

Sur la figure 36, on peut voir une cellule 36 appelée BSn (S(1:n), E)) comportant une entrée 18 et des sorties 19. L'entrée 18 est connectée à des buffers 1 mis en série. A la sortie de chaque buffer 1 mis en série est connectée à travers un second buffer 1 une sortie 19 de la cellule 36. Le dernier des buffers mis en série est relié à travers deux buffers 1 à deux sorties 19.

Sur la figure 37, on peut voir une cellule 37 appelée NBn (S(1:n), E) comportant un buffer inverseur 2 connecté à une série de buffers 1. La sortie du buffer inverseur 2 est connectée à une sortie 19 à travers un buffer 1. Entre deux buffers 1 placés en série est présente une connexion connectée à travers un buffer 1 à une sortie 19 de la cellule 37. Le dernier buffer connecté en série est relié à deux sorties 19 à travers deux buffers 1.

Sur la figure 38, on peut voir une cellule 38 appelée ETn (S, E(1:n)) comportant des entrées 18 et une sortie 19. La première entrée 18 est connectée à travers un buffer 1 à une première entrée d'une porte logique ET 13.

La seconde entrée 18 est connectée à travers un buffer 1 à une seconde entrée de la première porte logique ET 13.

La sortie de la première porte logique ET 13 est reliée à une première entrée d'une seconde porte logique ET 13.

La troisième entrée 18 est reliée à travers un buffer 1 à une seconde entrée de la porte logique ET 13.

La sortie de la seconde porte logique ET 13 est reliée à une première entrée de la troisième porte logique ET 13.

La quatrième entrée 18 est reliée à travers un buffer 1 à une seconde entrée de la troisième porte logique ET 13.

.

.

.

La sortie de la $i^{ième}$ porte logique ET 13 est reliée à une des entrées de la $(i+1)^{ième}$ porte logique ET 13.

La $i^{ième}$ entrée 18 est reliée à travers un buffer 1 à la seconde entrée de la $(i-1)^{ième}$ porte logique ET 13.

.

.

.

La dernière entrée 18 est reliée à travers un buffer 1 à la deuxième entrée de la dernière porte logique ET 13. La sortie de la dernière porte logique ET 13 est reliée à la sortie 19 de la cellule 38.

Sur la figure 39, on peut voir une cellule 39 appelée OSn (S, E(1:n)) comportant des entrées 18 et une sortie 19. La première entrée 18 est connectée à travers un buffer 1 à une première entrée d'une porte logique ET 13.

La seconde entrée 18 est connectée à travers un buffer 1 à une seconde entrée de la première porte logique ET 13.

La sortie de la première porte logique ET 13 est reliée à une première entrée d'une seconde porte logique ET 13.

La troisième entrée 18 est reliée à travers un buffer 1 à une seconde entrée de la deuxième porte logique ET 13.

La sortie de la seconde porte logique ET 13 est reliée à une première entrée de la troisième porte logique ET 13.

La quatrième entrée 18 est reliée à travers un buffer 1 à une seconde entrée de la troisième porte logique ET 13.

La sortie de la $i^{ième}$ porte logique ET 13 est reliée à une des entrées de la $(i+1)^{ième}$ porte logique ET 13.

La i**ième** entrée 18 est reliée à travers un buffer 1 à la seconde entrée de la (i-1)**ème** porte logique ET 13.

La sortie de la dernière porte logique ET 13 est reliée à l'entrée d'un buffer inverseur 2. La sortie du buffer inverseur 2 est reliée à la sortie 19 de la cellule 39.

Sur les figures suivantes, on peut voir des exemples non limitatifs des macrocellules utilisables pour décrire le schéma équivalent logique d'un circuit.

Sur la figure 40, on peut voir une cellule 50 appelée macrocellule ENT (S(1:v), E(1:n)). La cellule 50 comporte, placée en parallèle une pluralité des cellules 17 de la figure 29.

La macrocellule 50 de la figure 40 correspond au cas d'un P.L.A. dans lequel on utilise toutes les entrées directes et toutes les entrées inversées comme variables.

Avantageusement, la macrocellule 50 comporte autant de cellules 17 que le P.L.A. comporte d'entrées.

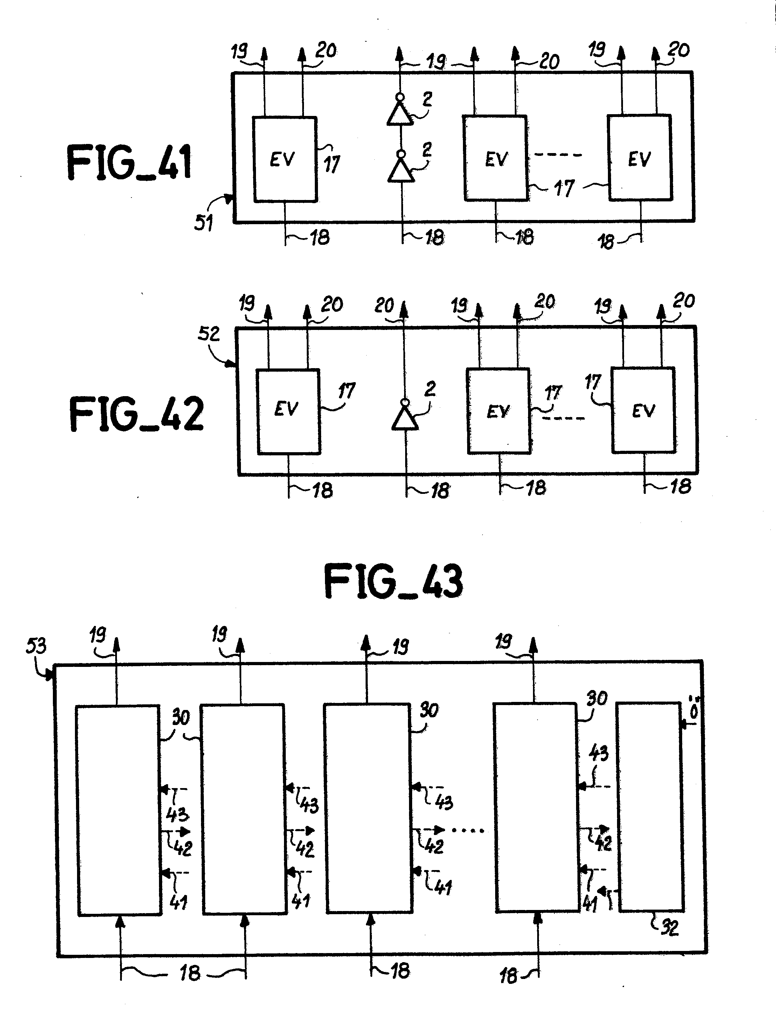

Sur la figure 41, on peut voir une variante de réalisation de la macrocellule 50 de la figure 40. La macrocellule 51 de la figure 41 correspond au cas où une entrée inversée du P.L.A. n'est pas utilisée comme variable. Chaque fois qu'une entrée inversée n'est pas une variable du P.L.A. la cellule 17 de la macrocellule 51 est remplacée par deux buffers inverseurs 2 placés en série. Sur la figure 41 est illustré un exemple dans lequel la seconde entrée inversée n'est pas utilisée comme variable du P.L.A.

Sur la figure 42, on peut voir une variante de réalisation du dispositif de la figure 40. Lorsqu'une entrée directe n'est pas utilisée comme variable du P.L.A. la cellule 17 correspondante de la macrocellule 52 est remplacée par un buffer inverseur 2. Dans l'exemple illustré sur la figure 42, la deuxième entrée directe n'est utilisée par aucun monôme du P.L.A..

Sur la figure 43, on peut voir une macrocellule 53 appelée macrocellule CCV (S(1:v), E(1:v)). La macrocellule 53 comporte une cellule 32 de la figure 32 et une pluralité des cellules 30 de la figure 30. Avantageusement, chaque cellule 30 correspond à une variable du P.L.A. considéré.

Les interconnexions des cellules 30 et 32 de la macrocellule 53 ne sont pas représentées car elles dépendent du P.L.A. que l'on veut modéliser.

Par exemple, les sorties 42 des cellules 30 sont reliées aux entrées 43 des cellules 30 correspondant aux variables adjacentes. Par exemple, si les variables 1 et 2 sont adjacentes il faut relier l'une des sorties 42 de la première cellule 30 à l'une des entrées 43 de la seconde cellule 30 et réciproquement. Chaque sortie 19 de la cellule 32 est reliée à deux entrées 41 non encore reliées de deux cellules 30 des variables adjacentes. Par exemple, si les variables 1 et 2 sont adjacentes, l'une des sorties 19 de la cellule 30 est reliée à l'une des entrées 41 de la première cellule 30 et à l'une des entrées 41 de la seconde cellule 30.

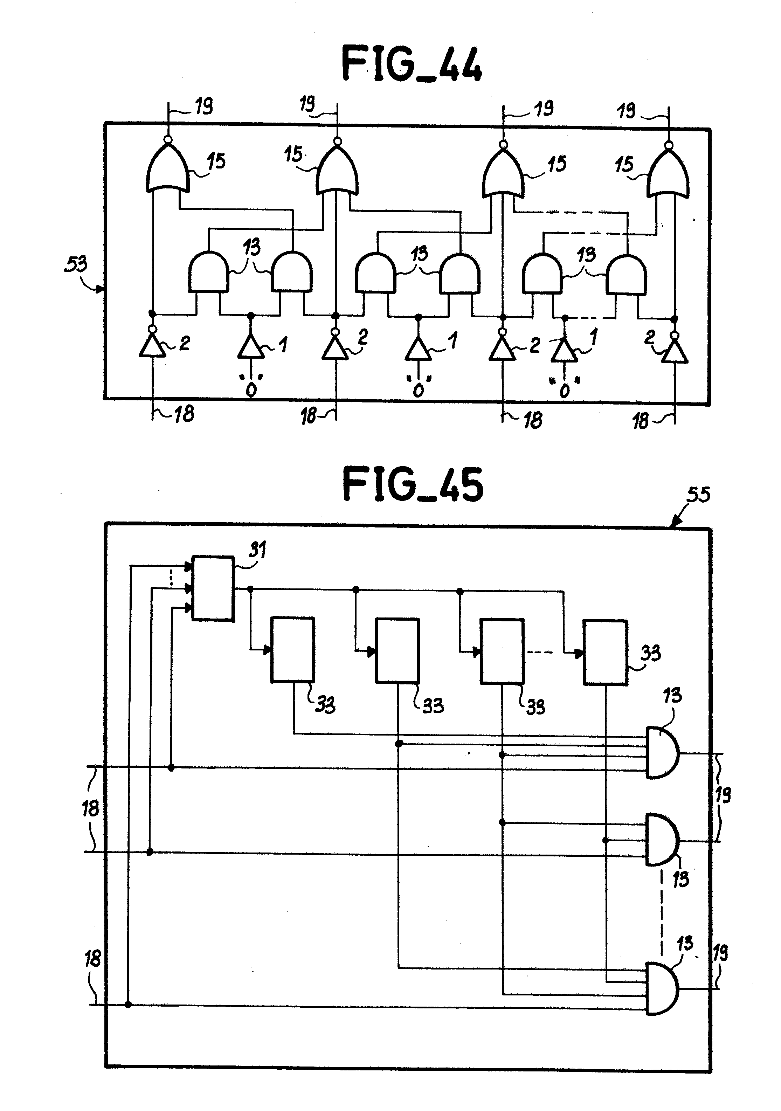

Sur la figure 44, on peut voir le schéma logique correspondant à la cellule 53 de la figure 43 dans le cas fréquent où chaque piste de variable a deux voisines adjacentes, une à droite, l'autre à gauche.

Chaque piste de variable 4 est connectée d'une part à une entrée d'une porte logique OU 16 (OR en terminologie anglo-saxonne), et d'autre part à une première entrée d'une porte logique ET 13. Les secondes entrées des portes logiques ET 13 sont connectées deux par deux à un buffer 1. La sortie de chaque porte logique ET 13 est reliée à une entrée desdites portes logiques OU 16 appartenant aux lignes de variable adjacentes. Appliquer un zéro logique au buffer d'entrée 1 permet de représenter par un collage à 1 un court-circuit entre deux pistes de variable 4. En effet, les courts-circuits entre deux pistes de variable 4 adjacentes ont pour conséquence de transformer l'expression des deux variables 4 en leur ET logique. Ce défaut se traduit donc sur le schéma de la figure 44 par un collage à 1 de la sortie d'un buffer.

Le court-circuit entre la première et la seconde lignes de variable 4 est équivalent au collage à 1 du noeud 21 situé entre ces deux lignes.

Un court-circuit entre la seconde et la troisième lignes de variable 4 sur le schéma 44 est équivalent au collage à 1 du noeud 22 situé entre ces deux lignes.

Sur la figure 45, on peut voir une macrocellule 55 appelée CMV (S(1:m), E(1:m)). La macrocellule 55 comporte une cellule 31 de la figure 31, des cellules 33 de la figure 33 et des portes logiques ET 13. La macrocellule 55 comporte m entrées 18 correspondant par exemple aux monômes du P.L.A.. Les entrées 18 sont connectées d'une part aux premières entrées de m portes logiques ET 13, et d'autre part à une cellule 31. La cellule 31 est reliée en parallèle à v cellules 33, v étant par exemple le nombre de variables du P.L.A. considéré.

Chaque cellule 33 correspond à une variable et est reliée aux portes logiques ET 13 reliées elles-mêmes aux monômes, dans l'expression desquels apparaît la variable correspondante.

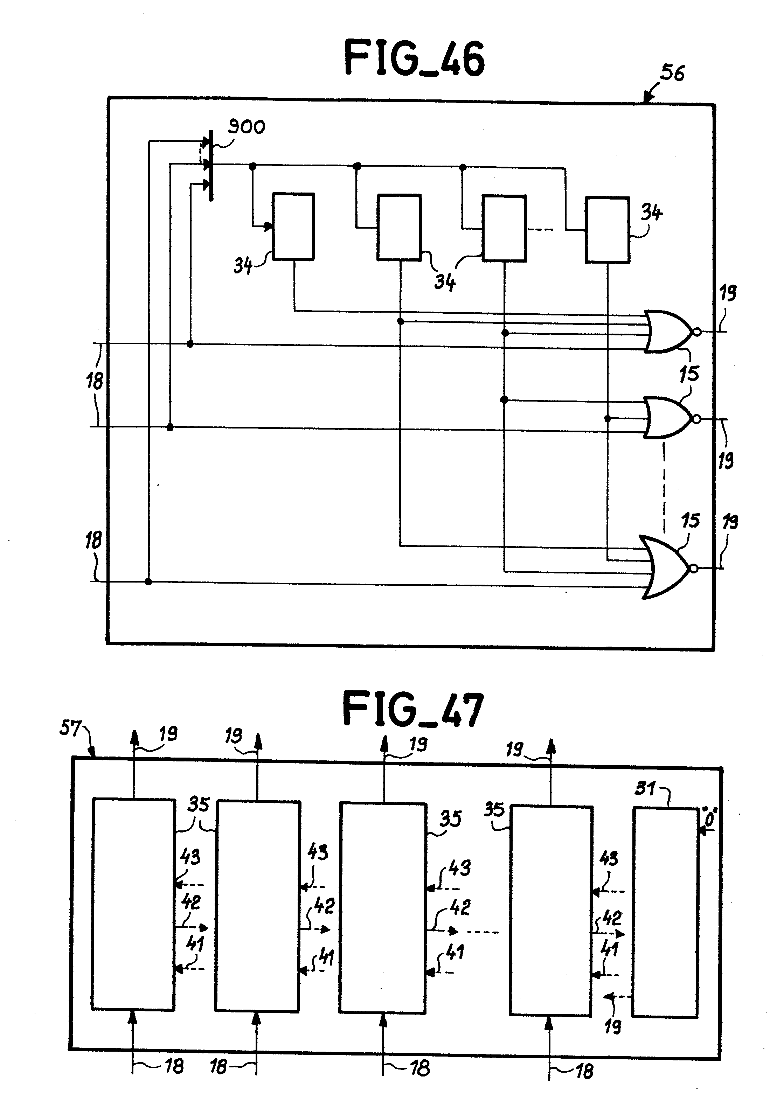

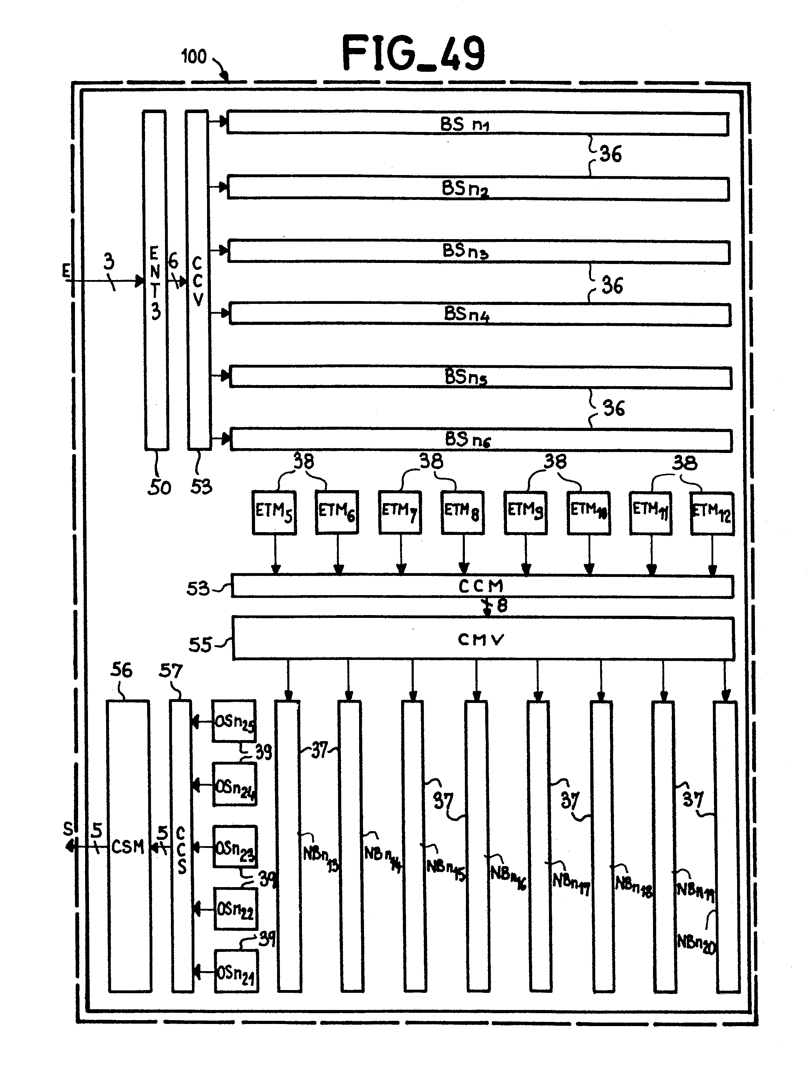

Sur la figure 46, on peut voir une macrocellule 56 appelée CSM (S(1:s), E(1:s)). La macrocellule 56 comporte s entrées 18, s étant par exemple le nombre de sorties que comporte le P.L.A. considéré. Chaque entrée 18 est reliée à un ensemble de m cellules 34 de la figure 34, m étant par exemple le nombre de monômes du P.L.A. considéré. En 900 on a représenté la concaténation des fils reliés aux entrées 18 et constituant un bus relié aux cellules 34.

Chaque cellule 34 correspond à un monôme et est reliée aux portes logiques OU 15 elles-mêmes reliées à une entrée 18 correspondant à une sortie du P.L.A. dans l'expression de laquelle apparaît le monôme correspondant.

Sur la figure 47, on peut voir une macrocellule 57 appelée CCS (S(1:s), E(1:s)). La cellule 47 comporte une cellule 31 de la figure 31 ainsi que des cellules 35 de la figure 35. L'interconnexion entre les cellules n'est pas représentée sur la figure 47 dans la mesure où elle dépend du P.L.A. considéré. Pour des pistes de sortie adjacentes il faut relier les sorties 42 aux entrées 43 des cellules correspondantes, et relier une des sorties 19 de la cellule 31 aux entrées 41 des deux cellules 35 considérées. Il faut remarquer que dans le cas des P.L.A. non optimisés et dans certains technologies les pistes de sortie 8 sont éloignées les unes des autres de deux pas ua minimum il n'y a alors pas de piste de sortie adjacente et on n'utilise pas la macrocellule 57.

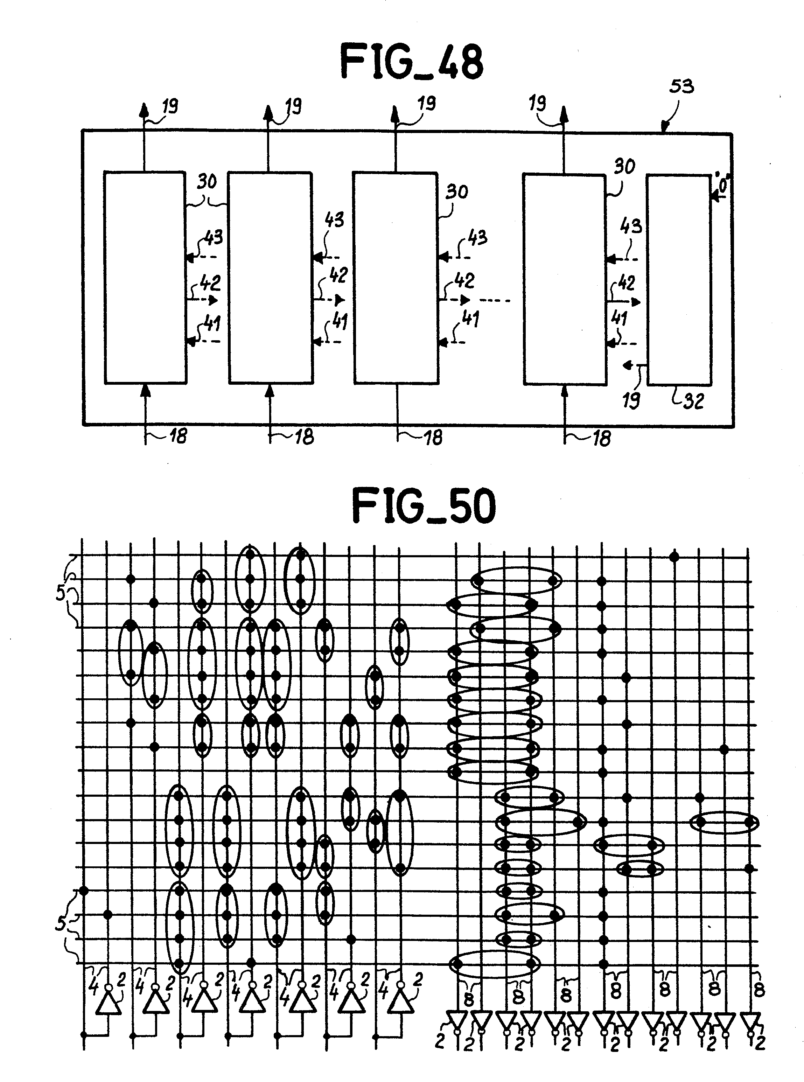

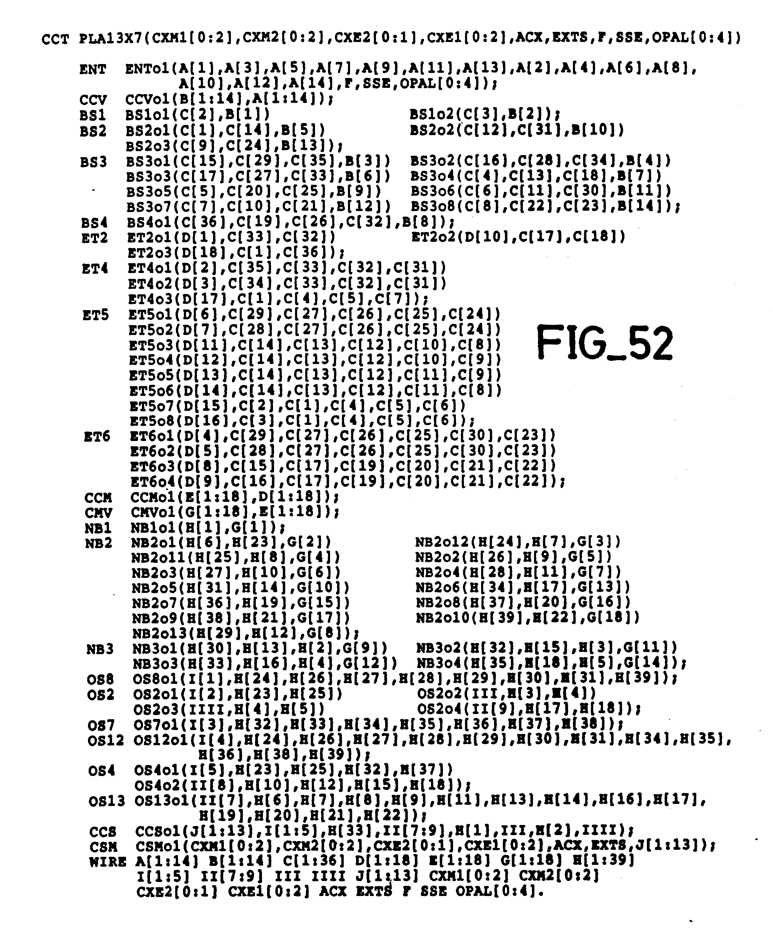

Sur la figure 48, on peut voir une macrocellule 53 appelée CCM (S(1:m), E(1:m)). La macrocellule 53 comporte une cellule 32 de la figure 32 et une pluralité des cellules 30 de la figure 30. Advantageusement, chaque cellule 30 correspond à un monôme du P.L.A. considéré.

Les interconnexions des cellules 30 et 32 de la macrocellule 53 ne sont pas représentées car elles dépendent du P.L.A. que l'on veut modéliser.

Par exemple, les sorties 42 des cellules 30 sont reliées aux entrées 43 des cellules 30 correspondant aux monômes adjacents. Par exemple, si les monômes 1 et 2 sont adjacents il faut relier l'une des sorties 42 de la première cellule 30 à l'une des entrées 43 de la seconde cellule 30 et réciproquement. Chaque sortie 19 de la cellule 32 est reliée à deux entrées 41 non encore reliées de deux cellules 30 des monômes adjacents. Par exemple, si les monômes 1 et 2 sont adjacents une interconnexion relie l'une des sorties 19 de la cellule 30 à l'une des entrées 41 de la première cellule 30 et à l'une des entrées 41 de la seconde cellule 30.

Sur la figure 49, on peut voir un exemple de schéma équivalent comportant des macrocellules d'un P.L.A. ayant trois entrées, six variables, huit monômes et cinq sorties. Le P.L.A. 100 comporte une entrée E sur trois bits. L'entrée E est reliée à une une macrocellule 50. La macrocellule 50 est reliée par six fils à une macrocellule 53. La macrocellule 53 est reliée en parallèle à six macrocellules 36. Les cellules 36 sont reliées à huit cellules 38. Le câblage dépendant du P.L.A. particulier considéré n'est pas représenté sur la figure 49. Les cellules 38 sont reliées à une cellule 53. La cellule 53 est reliée par huit fils à une cellule 55. La cellule 55 est reliée en parallèle à huit cellules 37. Les cellules 37 sont reliées en parallèle à cinq cellules 39. L'interconnexion entre les cellules 37 et 39 dépendant du P.L.A. particulier considéré n'est pas représentée sur la figure 49. Les cellules 39 sont reliées à une cellule 57. La cellule 57 est reliée par cinq fils à une cellule 56. La cellule 56 est reliée par cinq fils à la sortie du P.L.A.

Dans le paragraphe suivant on a donné un exemple d'une description en langage PAOLA d'un P.L.A. à sept entrées, quatorze variables, dix-huit monômes, treize sorties. Cette description contient toutes informations utiles permettant à un générateur automatique de vecteurs de test d'élaborer les séquences de test nécessaires au test logique du P.L.A.

```
XX10XXX    1001001000000
XX1110X    0011001000000
0X1111X    0010101000000
1X1111X    0011001000000
XX11010    0011000110001
XX11011    0011001010000
XX11001    0010011000101
XX11000    0010100100100
XX01XXX    1001001000000
X000100    1001001000010
X100100    1001000100000
X0001X1    1001001000000
```

```
X1001X1    1001000100000
X000110    1001001000000
X100110    0100101000000
X0000XX    1001001000000
X1000XX    0100101000000
XX00XXX    0000000001000
```

Sur la figure 50, on peut voir l'implémentation du P.L.A. décrit dans le paragraphe précédent. Les points représentent les connexions, on a entouré des ensembles de points appartenant à un même motif. On suppose que les pistes adjacentes sur ce schéma sont adjacentes physiquement.

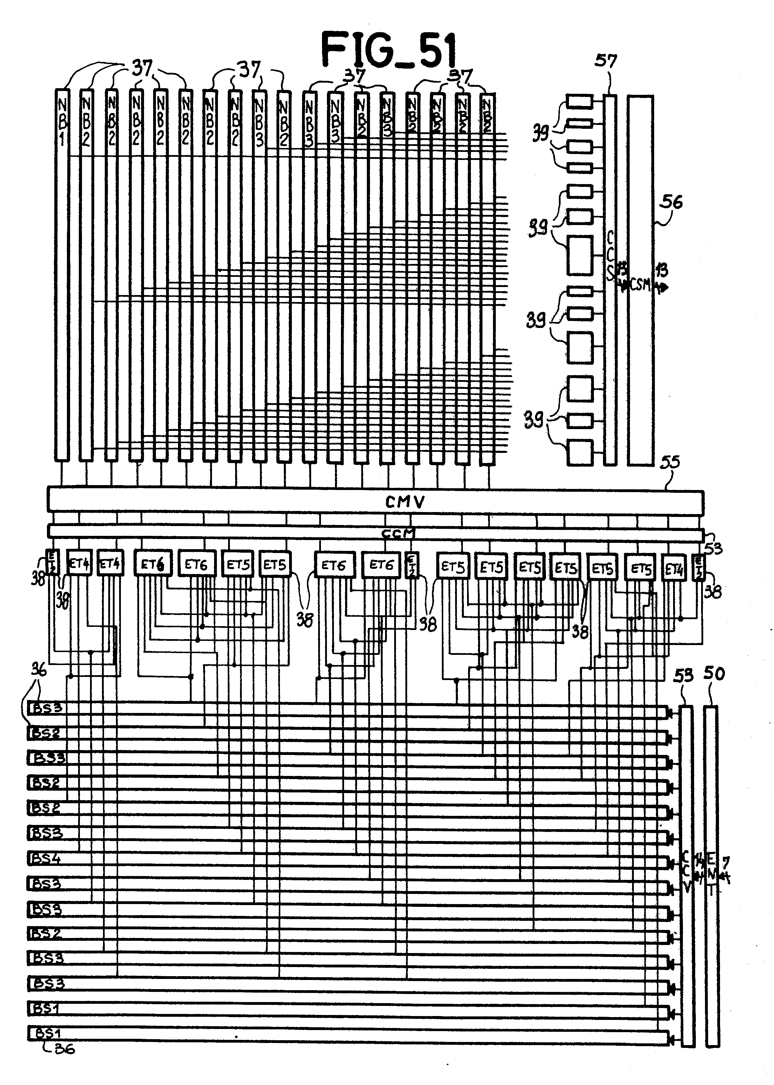

La figure 51 décrit les interconnexions particulières permettant le test du P.L.A. décrit dans le paragraphe précédent. Les fils d'entrée sont reliées à une macrocellule 50. La macrocellule 50 est reliée par quatorze fils à une macrocellule 53. La macrocellule 53 est reliée à quatorze cellules 36. Les cellules 36 sont reliées à dix-huit cellules 38. Les cellules 38 sont reliées à une macrocellule 53. La macrocellule 53 est reliée à une macrocellule 55. La macrocellule 55 est reliée à dix-huit cellules 37. Les cellules 37 sont reliées à treize macrocellules 39. Pour la clarté de la figure, les connexions entre les cellules 37 et 39 n'ont pas été représentées sur la figure. Les cellules 39 sont reliées à une macrocellule 57. La macrocellule 57 est reliée à une macrocellule 56 par treize fils. La macrocellule 56 est reliée par treize fils à treize sorties du P.L.A. Il est noté que pour les P.L.A. précédents il a été possible de tester 1650 fautes possibles avec vingt-deux vecteurs de tests. Un même vecteur de test est affecté de façon différente par divers défauts du circuit intégré à tester. Le taux de couverture obtenu étant égal au taux de couverture d'un test exhaustif.

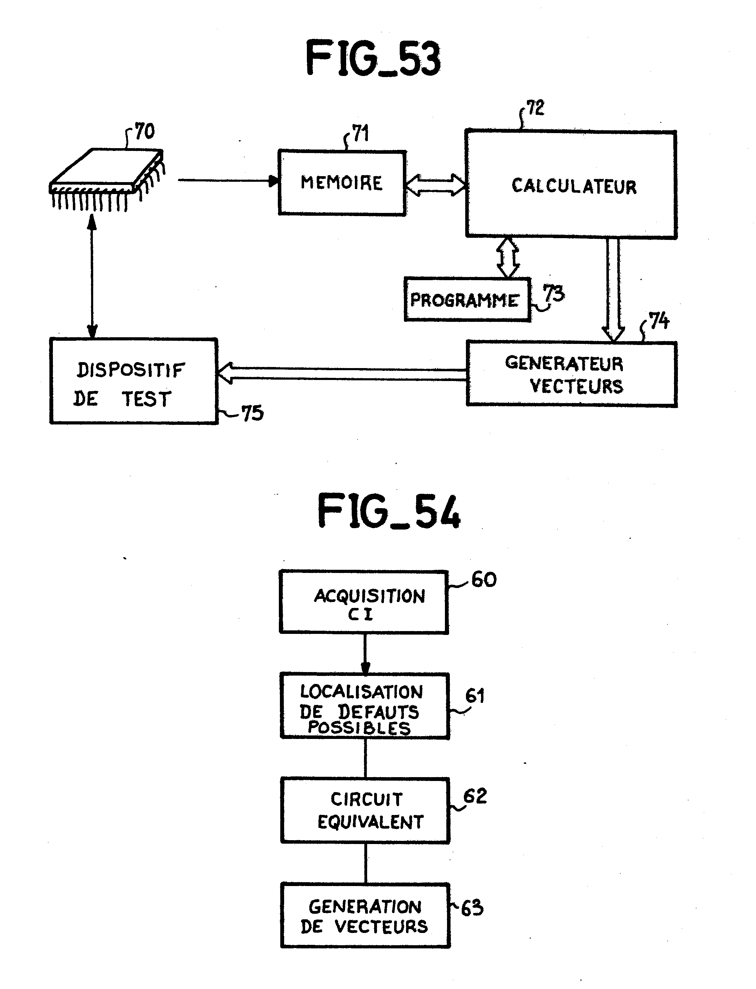

Sur la figure 52, on peut voir une description en langage de générateur automatique de séquence de test HILO du P.L.A. décrit précédemment.

Sur la figure 53, on peut voir un dispositif de test et de génération de vecteurs de test selon l'invention. Les caractéristiques d'un circuit intégré 70 sont introduites dans la mémoire 71 d'un calculateur 72. Par exemple on transmet, par des moyens de communication 79, au calculateur 72 les informations concernant le circuit intégré 70 à partir d'un dispositif de conception assité par ordinateur (CAO) ou d'un dispositif de saisie (non représenté). A l'aide d'un programme stocké sur un périphérique 73 le calculateur 72 détermine les défauts possibles du circuit intégré à examiner.

Dans une première variante de réalisation du dispositif selon l'invention, les calculateurs 72 génèrent au moins un vecteur de test qui, appliqué au circuit 70 serait modifié par la présence d'un défaut dudit circuit. Il est bien entendu qu'un même vecteur peut être modifier par plusieurs défauts.

Dans une seconde variante de réalisation du dispositif selon l'invention, le calculateur 72 élabore un schéma équivalent du circuit 70 susceptible d'être traité par un générateur des vecteurs de tests 74 de type classique. Dans ce cas, le calculateur 72 transmet au générateur de vecteurs de tests 74 la description du schéma équivalent du circuit 70.

La générateurs de vecteurs de tests 74 génèrent les vecteurs de tests nécessaires aux tests du schéma équivalent. Il est bien entendu que cet ensemble de vecteurs de tests du schéma équivalent permet de tester et de détecter les défauts du circuit 70. La séquence de vecteurs de test généré par les générateurs 74 est transmise à un dispositif de test 75 de type classique. Le dispositif de test 75 permet de tester les circuits 70.

Il est bien entendu possible d'utiliser un calculateur universel pour réaliser la génération des vecteurs de test.

La figure 54 est un organigramme d'un programme susceptible d'être mis en oeuvre par un calculateur 72 de la figure 53.

En 60 le calculateur effectue l'acquisition des données concernant les circuits intégrés à tester.

On va en 61.

En 61 le calculateur effectue la localisation des défauts possibles du circuit à tester.

On va en 62.

En 62 le calculateur 72 détermine un circuit équivalent au circuit à tester.

On va en 63.

En 63 soit le calculateur 72, soit, avantageusement, un générateur de vecteur de test 74 effectue la génération des vecteurs de tests du circuit équivalent au circuit intégré 70.

Le dispositif selon la présente invention s'applique aux tests de circuits intégrés, principalement des circuits intégrés de type combinatoire. De plus, la présente invention s'applique particulièrement bien aux tests des P.L.A. dans la mesure où elle est l'unique méthode de test des P.L.A. de dimensions importantes.

## Revendications

1. Dispositif de génération de vecteurs de test pour circuits intégrés, caractérisé par le fait qu'il comporte des moyens (79) de communication et au moins un calculateur (72), les moyens (79) de communication permettant d'acquérir une description d'un circuit, le calculateur (72) étant susceptible de déterminer les défauts possibles dans le circuit intégré (70) et d'associer aux défauts logiques possibles du circuit intégré (70) un ensemble de vecteurs de test, chaque défaut de circuit intégré (70) étant susceptible de modifier au moins au vecteur.

2. Dispositif selon la revendication 1, caractérisé par le fait que le calculateur (72) est susceptible d'associer un vecteur de test à chaque défaut logique possible.

3. Dispositif selon la revendication 1 ou 2, caractérisé par le fait que le circuit intégré (70) est un circuit combinatoire.

4. Dispositif selon la revendication 1, 2 ou 3, caractérisé par le fait que le circuit intégré (70) est un circuit logique programmable (P.L.A.).

5. Procédé de génération de vecteurs de test pour circuits intégrés, caractérisé par le fait que ledit procédé comporte une étape de détermination de défauts logiques possibles et une étape de génération d'au moins un vecteur de test par défaut logique possible, ledit vecteur appliqué audit circuit logique donnera une réponse qui sera affectée par l'existence dudit défaut logique.

6. Procédé selon la revendication 5, caractérisé par le fait que l'étape de détermination de défaut comporte une étape de détermination de cellules équivalentes ou des parties des circuits intégrés (17, 30, 31, 32, 33, 34, 35, 36, 37, 38, 39, 50, 51, 52, 53, 55, 56, 57).

7. Procédé selon la revendication 6, caractérisé par le fait qu'il comporte l'étape de détermination d'un schéma équivalent au circuit intégré, ledit schéma équivalent comportant un ensemble de cellules (17, 30, 31, 32, 33, 34, 35, 36, 37, 38, 39, 50, 51, 52, 53, 55, 56, 57) interconnectées.

8. Procédé selon la revendication 6 ou 7, caractérisé par le fait que les cellules sont hiérarchisées, une cellule pouvant être constituée par un ensemble de cellules (17, 30, 31, 32, 33, 34, 35, 36, 37, 38, 39) interconnectées de moindre complexité,

9. Procédé selon la revendication 7 ou 8, caractérisé par le fait que l'étape de génération de vecteur de test appliquée à un circuit intégré donne une réponse qui est affectée par la présence d'un défaut logique dudit circuit est réalisé par un générateur de vecteurs de test classique à partir du schéma équivalent dudit circuit.

10. Procédé de test de circuits intégrés, caractérisé par le fait qu'il utilise le dispositif selon la revendication 1 à 4.

11. Procédé de test de circuits intégrés, caractérisé par le fait qu'il utilise les vecteurs de test générés par le procédé selon l'une quelconque des revendications 5 à 9.

0268506

# FIG_1

# FIG_2

0268506

FIG_3

FIG_4

0268506

# FIG_5

# FIG_6

0268506

**FIG_7**

**FIG_8**

**FIG_9**

**FIG_11**

**FIG_12**

**FIG_10**

0268506

## FIG_13

## FIG_14

## FIG_15

## FIG_16

## FIG_17

## FIG_18

0268506

FIG_19

FIG_20

FIG_21

FIG_22

0268506

# FIG_23

# FIG_24

# FIG_25

# FIG_26

0268506

FIG_27

FIG_28

0268506

FIG_29

FIG_30

FIG_31

FIG_32

FIG_33

0268506

**FIG_34**

**FIG_35**

**FIG_36**

**FIG_37**

0268506

FIG_38

FIG_39

FIG_40

FIG_41

FIG_42

FIG_43

0268506

# FIG_44

# FIG_45

0268506

## FIG_46

## FIG_47

0268506

# FIG_49

0268506

## FIG_48

## FIG_50

0268506

```
CCT PLA13X7(CXM1[0:2],CXM2[0:2],CXE2[0:1],CXE1[0:2],ACX,EXTS,F,SSE,OPAL[0:4])

    ENT  ENTo1(A[1],A[3],A[5],A[7],A[9],A[11],A[13],A[2],A[4],A[6],A[8],
              A[10],A[12],A[14],F,SSE,OPAL[0:4]);
    CCV  CCVo1(B[1:14],A[1:14]);
    BS1  BS1o1(C[2],B[1])                    BS1o2(C[3],B[2]);
    BS2  BS2o1(C[1],C[14],B[5])              BS2o2(C[12],C[31],B[10])
         BS2o3(C[9],C[24],B[13]);
    BS3  BS3o1(C[15],C[29],C[35],B[3])  BS3o2(C[16],C[28],C[34],B[4])
         BS3o3(C[17],C[27],C[33],B[6])  BS3o4(C[4],C[13],C[18],B[7])
         BS3o5(C[5],C[20],C[25],B[9])   BS3o6(C[6],C[11],C[30],B[11])
         BS3o7(C[7],C[10],C[21],B[12])  BS3o8(C[8],C[22],C[23],B[14]);
    BS4  BS4o1(C[36],C[19],C[26],C[32],B[8]);
    ET2  ET2o1(D[1],C[33],C[32])             ET2o2(D[10],C[17],C[18])
         ET2o3(D[18],C[1],C[36]);
    ET4  ET4o1(D[2],C[35],C[33],C[32],C[31])
         ET4o2(D[3],C[34],C[33],C[32],C[31])
         ET4o3(D[17],C[1],C[4],C[5],C[7]);
    ET5  ET5o1(D[6],C[29],C[27],C[26],C[25],C[24])
         ET5o2(D[7],C[28],C[27],C[26],C[25],C[24])
         ET5o3(D[11],C[14],C[13],C[12],C[10],C[8])
         ET5o4(D[12],C[14],C[13],C[12],C[10],C[9])             FIG_52
         ET5o5(D[13],C[14],C[13],C[12],C[11],C[9])
         ET5o6(D[14],C[14],C[13],C[12],C[11],C[8])
         ET5o7(D[15],C[2],C[1],C[4],C[5],C[6])
         ET5o8(D[16],C[3],C[1],C[4],C[5],C[6]);
    ET6  ET6o1(D[4],C[29],C[27],C[26],C[25],C[30],C[23])
         ET6o2(D[5],C[28],C[27],C[26],C[25],C[30],C[23])
         ET6o3(D[8],C[15],C[17],C[19],C[20],C[21],C[22])
         ET6o4(D[9],C[16],C[17],C[19],C[20],C[21],C[22]);
    CCM  CCMo1(E[1:18],D[1:18]);
    CMV  CMVo1(G[1:18],E[1:18]);
    NB1  NB1o1(H[1],G[1]);
    NB2  NB2o1(H[6],H[23],G[2])              NB2o12(H[24],H[7],G[3])
         NB2o11(H[25],H[8],G[4])            NB2o2(H[26],H[9],G[5])
         NB2o3(H[27],H[10],G[6])            NB2o4(H[28],H[11],G[7])
         NB2o5(H[31],H[14],G[10])           NB2o6(H[34],H[17],G[13])
         NB2o7(H[36],H[19],G[15])           NB2o8(H[37],H[20],G[16])
         NB2o9(H[38],H[21],G[17])           NB2o10(H[39],H[22],G[18])
         NB2o13(H[29],H[12],G[8]);
    NB3  NB3o1(H[30],H[13],H[2],G[9])        NB3o2(H[32],H[15],H[3],G[11])
         NB3o3(H[33],H[16],H[4],G[12])       NB3o4(H[35],H[18],H[5],G[14]);
    OS8  OS8o1(I[1],H[24],H[26],H[27],H[28],H[29],H[30],H[31],H[39]);
    OS2  OS2o1(I[2],H[23],H[25])             OS2o2(III,H[3],H[4])
         OS2o3(IIII,H[4],H[5])               OS2o4(II[9],H[17],H[18]);
    OS7  OS7o1(I[3],H[32],H[33],H[34],H[35],H[36],H[37],H[38]);
    OS12 OS12o1(I[4],H[24],H[26],H[27],H[28],H[29],H[30],H[31],H[34],H[35],
              H[36],H[38],H[39]);
    OS4  OS4o1(I[5],H[23],H[25],H[32],H[37])
         OS4o2(II[8],H[10],H[12],H[15],H[18]);
    OS13 OS13o1(II[7],H[6],H[7],H[8],H[9],H[11],H[13],H[14],H[16],H[17],
              H[19],H[20],H[21],H[22]);
    CCS  CCSo1(J[1:13],I[1:5],H[33],II[7:9],H[1],III,H[2],IIII);
    CSM  CSMo1(CXM1[0:2],CXM2[0:2],CXE2[0:1],CXE1[0:2],ACX,EXTS,J[1:13]);
    WIRE A[1:14] B[1:14] C[1:36] D[1:18] E[1:18] G[1:18] H[1:39]
         I[1:5] II[7:9] III IIII J[1:13] CXM1[0:2] CXM2[0:2]
         CXE2[0:1] CXE1[0:2] ACX EXTS F SSE OPAL[0:4].
```

FIG_51

0268506

# FIG_53

# FIG_54

Office européen
des brevets

**RAPPORT DE RECHERCHE EUROPEENNE**

Numero de la demande

EP 87 40 2217

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | IEEE DESIGN & TEST OF COMPUTERS, vol. 2, no. 5, octobre 1985, pages 54-60, IEEE, New York, US; S. FUNATSU et al.: "An automatic test-generation system for large digital circuits" * Page 57, lignes 14-41 * --- | 1-2,5 | G 01 R 31/28 |
| X | IEEE INTERCON CONFERENCE RECORD, 8-10 avril 1975, pages 1-9, New York, US; S.S. YAU et al.: "A survey of fault diagnosis of digital circuits" * Page 5, colonne 2, ligne 17 - page 6, colonne 1, ligne 25; figure 5 * --- | 1,5 | |
| A | IEEE TRANSACTIONS ON COMPUTERS, vol. C-28, no. 11, novembre 1979, pages 845-853, IEEE, New York, US; J.E. SMITH: "Detection of faults in programmable logic arrays" * Page 848, colonne 1, lignes 7-19; page 849, colonne 1, lignes 25-30 * --- | 1-5 | |
| A | IEEE TRANSACTIONS ON COMPUTERS, vol. C-31, no. 2, février 1982, pages 129-139, IEEE, New York, US; Y.M. EL-ZIQ et al.: Fault diagnosis of MOS combinational networks" * En entier * --- | 1,3,5-8 | DOMAINES TECHNIQUES RECHERCHES (Int. Cl.4) G 01 R 31/28 G 06 F 11/26 |
| A | NINTH ANNUAL INTERNATIONAL SYMPOSIUM ON FAULT-TOLERANT COMPUTING, Madison, Wisconsin, 20-22 juin 1979, pages 227-234, IEEE, New York, US; V.K. AGARWAL: "Multiple fault detection in programmable logic arrays" * Page 227, colonne 1, ligne 1 - colonne 2, ligne 45 * --- -/- | 1,4,5-7 | |

Le présent rapport a été établi pour toutes les revendications

| Lieu de la recherche | Date d'achèvement de la recherche | Examinateur |
|---|---|---|
| LA HAYE | 04-12-1987 | HERREMAN,G.L.O. |

Office européen
des brevets

**RAPPORT DE RECHERCHE EUROPEENNE**

Numero de la demande

EP 87 40 2217

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-1 512 238 (OLIVETTI - GENERAL ELECTRIC) <br> * Page 1, colonne 2, lignes 4-30; résumé * <br> ───── | 5,6 | |
| | | | **DOMAINES TECHNIQUES RECHERCHES (Int. Cl.4)** |

Le présent rapport a été établi pour toutes les revendications

| Lieu de la recherche | Date d'achèvement de la recherche | Examinateur |
|---|---|---|
| LA HAYE | 04-12-1987 | HERREMAN,G.L.O. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
·······························································
& : membre de la même famille, document correspondant

EPO FORM 1503 03.82 (P0402)